# EUROPEAN PATENT APPLICATION

(11) **EP 4 700 480 A1**
(43) Date of publication of application: **25.02.2026**
(21) Application number: 25194744.6
(22) Date of filing: 08.08.2025
(51) Int. Cl.: G03F 7/09

(54) **COMPOSITION FOR FORMING ORGANIC FILM, METHOD FOR FORMING ORGANIC FILM, PATTERNING PROCESS, AND POLYMER**

(30) Priority: 16.08.2024 JP 2024137454
(71) Applicant: SHIN-ETSU CHEMICAL CO., LTD., Tokyo 1000005 (JP)
(72) Inventor: Niida, Keisuke, Niigata (JP); Yamamoto, Yasuyuki, Niigata (JP)
(74) Representative: Schicker, Silvia

(57) **Abstract**

The present invention is a composition for forming an organic film, the composition containing (A) a material for forming an organic film, (B) a polymer having a repeating unit represented by the following formula (B1), and (C) a solvent: 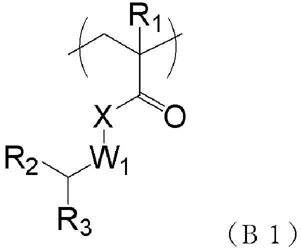 wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom. This can provide a polymer that is useful for a film forming material, has a low environmental impact, and does not fall under PFAS. Also provided are an organic film material composition containing this polymer that has no coating defects such as pinholes on a substrate (wafer), and is excellent in coatability such as film formability (in-plane uniformity) and filling characteristic, and a method for forming an organic film. Also provided is a patterning process with excellent process tolerance using a resist film that uses this composition for forming an organic film.

## Description

### TECHNICAL FIELD

The present invention relates to a composition for forming an organic film capable of forming an organic film for a multilayer resist for microfabrication in the manufacture of a semiconductor device or the like, or an organic film for planarization in the manufacture of a semiconductor device or the like, a method for forming an organic film using the composition, a patterning process using the composition, and a polymer used for the composition.

### BACKGROUND ART

As LSIs become more highly integrated and faster, pattern rules are rapidly becoming finer. This is because 5G high speed communication and artificial intelligence (AI) are becoming increasingly popular, and high performance devices for processing them are needed. As the most advanced miniaturization technology, mass production of devices with 5 nm nodes is carried out using extreme ultraviolet (EUV) lithography with a wavelength of 13.5 nm. Furthermore, EUV lithography is also being considered for the next generation devices with 3 nm nodes and the next after next generation devices with 2 nm nodes.

As the thinning of resist patterns progresses as described above, a monolayer resist method, which is employed as a typical resist patterning process, becomes difficult to use as a patterning process, and it is known that, as a fine pattern processing method, a multilayer resist method, in which a pattern is formed by laminating films having different dry etching properties, is excellent for forming a pattern with a high aspect ratio on an uneven substrate. There has been developed and put into practical use a three-layer resist method in which a photoresist layer made of an organic photosensitive polymer used in a monolayer resist method is combined with a middle layer made of a silicon-based polymer or a silicon-based CVD film, and an underlayer made of an organic polymer (Patent Document 1).

In this three-layer resist method, for example, an organic film made of novolac or the like is uniformly formed on a substrate to be processed as a resist underlayer film (organic underlayer film), a silicon-containing resist middle layer film is formed thereon as a resist middle layer film, and a normal organic photoresist film is formed thereon as a resist upper layer film. For dry etching with fluorine-based gas plasma, the organic resist upper layer film has better etching selectivity relative to the silicon-containing resist middle layer film, and thus the resist pattern is transferred to the silicon-containing resist middle layer film by using dry etching with fluorine-based gas plasma. According to this method, it is possible to transfer the pattern to the silicon-containing resist middle layer film even when using a resist composition that is difficult to form a pattern with a sufficient film thickness to directly process the substrate to be processed or a resist composition that does not have sufficient dry etching resistance to process the substrate, and then, by carrying out pattern transfer using dry etching with oxygen-based gas plasma, it is possible to obtain a pattern of the novolac film (resist underlayer film) with sufficient dry etching resistance for processing.

Although a number of technologies for the organic underlayer film as mentioned above are already known (for example, Patent Document 2), the need for excellent filling property in addition to dry etching property has been increasing with the progress of miniaturization in recent years. There is a need for an organic film material that can uniformly form a film on a base substrate to be processed, even on a substrate or material to be processed with a complicated shape, and that has filling property that can fill in the required pattern with no voids.

The organic underlayer film as mentioned above is formed using a coater/developer capable of carrying out treatments such as spin coating process, EBR process, and baking process when manufacturing semiconductor substrates and the like. The EBR (edge bead removal) process is a process in which a film is formed on a substrate (wafer) by spin coating and then the film at the edge of the substrate is removed with a removing solution for the purpose of preventing contamination of the substrate conveying arm of the coater/developer. The removing solution used in the EBR process includes a mixed solution of propylene glycol monomethyl ether acetate and propylene glycol monomethyl ether (30% by mass : 70% by mass), which is widely used in the EBR process for resist films and resist underlayer films (silicon-containing middle layer films and organic underlayer films).

The outer circumference of the organic underlayer film may have a thick film thickness (humps) due to the influence of the remover in the EBR process. Since humps cause defects in the dry etching process during the substrate processing mentioned above, there is a demand for an organic underlayer film with suppressed humps.

Resist materials used for photolithography using the organic photosensitive polymer described above, as well as the organic underlayer film, form a film by applying a solution by spin coating or other methods and evaporating the solvent by baking in the same manner as for the organic underlayer film. As with the organic underlayer film, the film thickness after baking is required to be uniform and flat, and the requirements for uniformity and flatness have become more demanding from year to year.

In recent years, there is a demand for thicker resist films in the 3D-NAND memory application, which requires even greater flatness. As the film thickness increases, flatness in the film becomes more difficult to achieve. On the other hand, as miniaturization progresses, thinner films are being produced, and in this case, the risk of generation of pinhole defects and the like is increasing.

Although examples of film materials using organic matters used for semiconductor processing materials are described above, it would be a great industrial advantage to obtain a material that forms a film with in-plane uniformity of film thickness and with no pinholes, even for film forming materials not using organic matters.

In recent years, health effects of perfluoroalkyl compounds (PFAS) have been pointed out, and there is a movement to establish restrictions on the manufacture and sale of PFAS compounds in the EU REACH. Perfluoroalkyl compounds are used in a wide variety of applications, including water repellents, surface treatment agents, emulsifiers, fire extinguishing agents, coating agents, and others due to their structural properties such as water and oil repellency, heat resistance, chemical resistance, and non-light absorption, making the development of alternative materials without PFAS structures an urgent need.

As an example of materials using perfluoroalkyl compounds as mentioned above, surfactants having a fluoroalkyl group or silicone chain are highly effective in lowering surface tension, and in particular, fluoroalkyl group-based surfactants with a low risk of generating silicon-derived particles after dry ashing of resist films are widely used (Patent Documents 3 and 4). In addition, not only in resist materials, fluorinated surfactants are applied also in top coats formed on the upper layer of resists and in underlayer antireflective films formed under resists (Patent Document 5).

It is necessary to use materials that do not fall under PFAS regulations from the viewpoint of future regulatory tightening. For example, as the surfactants described above, a surfactant having a trifluoromethoxy group or a pentafluorosulfanyl group and use thereof are proposed (Patent Document 6). Also, in the field of resist materials, a resist material using a photoacid generator and the like is proposed as well (Patent Document 7). Furthermore, a fluorine-free surfactant is proposed (Patent Document 8).

### CITATION LIST

### PATENT LITERATURE

Patent Document 1: JP 2005-128509 A
Patent Document 2: JP 2004-205685 A
Patent Document 3: JP H06-186735 A
Patent Document 4: JP H06-214380 A
Patent Document 5: JP 2010-139822 A
Patent Document 6: Japanese Translation of PCT International Application Publication No. 2008-526792
Patent Document 7: WO 2023-223624 A1
Patent Document 8: WO 2022-073921 A1

### SUMMARY OF INVENTION

### TECHNICAL PROBLEM

The present invention has been made in view of the above circumstances, and provides a polymer not containing fluorine atom. By using an organic film material composition containing this polymer, it is possible to form a film with excellent coatability, such as coating defects such as pinholes on a substrate (wafer), film formability (in-plane uniformity), and filling results. Furthermore, by using this composition for forming an organic film as an organic underlayer film material, it is possible to provide an organic film that is excellent in process tolerance when used as an organic underlayer film for a multilayer resist, and a method for forming an organic film and a patterning process using this composition for forming an organic film can be provided. The above is useful as a film forming material with a low environmental impact since it makes it possible to provide a film forming material that does not fall under PFAS.

### SOLUTION TO PROBLEM

In order to solve the above problems, the present invention provides a composition for forming an organic film, the composition comprising (A) a material for forming an organic film, (B) a polymer having a repeating unit represented by the following formula (B1), and (C) a solvent: 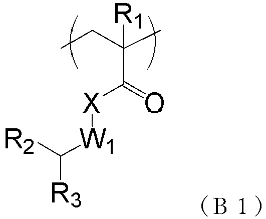 wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom.

With such a composition for forming an organic film, the branched long chain alkyl group in the formula (B1) demonstrates a surfactant effect, making it possible to form an organic film that is excellent in in-plane uniformity and filling property, and can also suppress the formation of humps caused by the remover in the EBR process.

In the present invention, it is preferable that W₁ in the formula (B1) is a group represented by the following formula (B2): 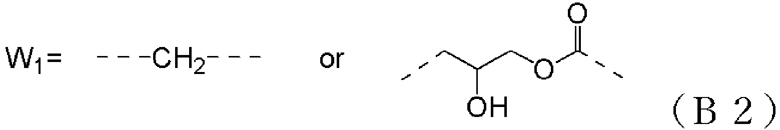 wherein broken lines represent a point of attachment to X and a point of attachment to the carbon atom to which R₂ and R₃ are bonded in the formula (B1), and W₁ has one of the structures represented by the formula (B2) or has two thereof.

When the composition for forming an organic film comprises such a polymer, it is preferable since an organic film that is more excellent in in-plane uniformity can be formed.

In the present invention, it is preferable that the polymer (B) further comprises one of or two or more of repeating units represented by the following general formula (B3): 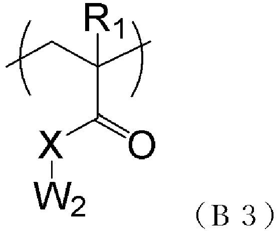 wherein R₁ and X are the same as described above, and W₂ is a monovalent organic group not containing fluorine atom and optionally containing an oxygen atom.

By containing such a unit, solvent solubility can be enhanced.

In the present invention, it is preferable that W₂ in the formula (B3) is a group represented by the following formula (B4): 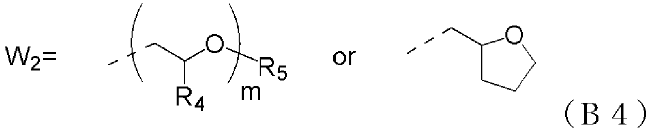 wherein R₄ is a hydrogen atom or a methyl group, R₅ is a hydrogen atom or a monovalent organic group having 1 to 10 carbon atoms and not containing fluorine atom, and m is an integer of 4 to 20.

By containing such a unit, the thermal decomposability, surfactant effect, and flowability of the polymer can be adjusted, resulting in a compound that more reliably achieves both film formability and filling characteristic, etc., and furthermore, solubility in the resist solvent can be ensured.

Also, it is preferable that the component (B) has a weight average molecular weight of 1000 to 30000.

Such a range of weight average molecular weight makes it possible to form an organic film that is more excellent in film formability and filling property.

Also, it is preferable that the content of the component (B) is 0.01 parts by mass to 5 parts by mass based on 100 parts by mass of the content of the (A) material for forming an organic film.

When the composition for forming an organic film comprises the component (B) in such a content, it is preferable since the in-plane uniformity of the organic film formed is more excellent.

The present invention also provides a method for forming an organic film to be used in a manufacturing process of a semiconductor device, the method comprising spin-coating the composition for forming an organic film of the present invention described above on a substrate to be processed to obtain a coating film, and forming a cured film by a heat treatment at a temperature of 100°C or higher and 600°C or lower for a range of 10 to 600 seconds to form an organic film.

The composition for forming an organic film of the present invention is particularly useful in the case where a pattern with a complicated shape on a substrate to be processed is filled by spin coating, an organic film that is excellent in in-plane uniformity is formed, and the organic film at the edge is removed while suppressing humps in the EBR process. Therefore, according to the method for forming an organic film of the present invention, an organic film can be formed that exhibits excellent film formability, excellent filling property, and excellent hump suppressing property during the EBR process, as well as excellent process tolerance when used as an organic film for a multilayer resist.

The present invention also provides a patterning process comprising: forming an organic film on a body to be processed using the composition for forming an organic film of the present invention described above; forming a silicon-containing resist middle layer film on the organic film using a silicon-containing resist middle layer film material; forming a resist upper layer film on the silicon-containing resist middle layer film using a resist upper layer film material composed of a photoresist composition; forming a circuit pattern in the resist upper layer film; transferring the pattern to the silicon-containing resist middle layer film by etching using as a mask the resist upper layer film in which the circuit pattern has been formed; transferring the pattern to the organic film by etching using as a mask the silicon-containing resist middle layer film to which the pattern has been transferred; and further forming the pattern in the body to be processed by etching using as a mask the organic film to which the pattern has been transferred.

The present invention also provides a patterning process comprising: forming an organic film on a body to be processed using the composition for forming an organic film of the present invention described above; forming a silicon-containing resist middle layer film on the organic film using a silicon-containing resist middle layer film material; forming an organic antireflective film or an adhesion film on the silicon-containing resist middle layer film; forming a resist upper layer film on the organic antireflective film or adhesion film using a resist upper layer film material composed of a photoresist composition; forming a circuit pattern in the resist upper layer film; transferring the pattern to the organic antireflective film or adhesion film and the silicon-containing resist middle layer film by etching using as a mask the resist upper layer film in which the circuit pattern has been formed; transferring the pattern to the organic film by etching using as a mask the silicon-containing resist middle layer film to which the pattern has been transferred; and further forming the pattern in the body to be processed by etching using as a mask the organic film to which the pattern has been transferred.

The present invention also provides a patterning process comprising: forming an organic film on a body to be processed using the composition for forming an organic film of the present invention described above; forming an inorganic hard mask selected from the group consisting of a silicon oxide film, a silicon nitride film, and a silicon oxynitride film on the organic film; forming a resist upper layer film on the inorganic hard mask using a resist upper layer film material composed of a photoresist composition; forming a circuit pattern in the resist upper layer film; transferring the pattern to the inorganic hard mask by etching using as a mask the resist upper layer film in which the circuit pattern has been formed; transferring the pattern to the organic film by etching using as a mask the inorganic hard mask to which the pattern has been transferred; and further forming the pattern in the body to be processed by etching using as a mask the organic film to which the pattern has been transferred.

The present invention also provides a patterning process comprising: forming an organic film on a body to be processed using the composition for forming an organic film of the present invention described above; forming an inorganic hard mask selected from the group consisting of a silicon oxide film, a silicon nitride film, and a silicon oxynitride film on the organic film; forming an organic antireflective film or an adhesion film on the inorganic hard mask; forming a resist upper layer film on the organic antireflective film or adhesion film using a resist upper layer film material composed of a photoresist composition; forming a circuit pattern in the resist upper layer film; transferring the pattern to the organic antireflective film or adhesion film and the inorganic hard mask by etching using as a mask the resist upper layer film in which the circuit pattern has been formed; transferring the pattern to the organic film by etching using as a mask the inorganic hard mask to which the pattern has been transferred; and further forming the pattern in the body to be processed by etching using as a mask the organic film to which the pattern has been transferred.

As described above, the composition for forming an organic film of the present invention can be suitably used for various patterning processes, such as a three-layer resist process using a silicon-containing resist middle layer film or an inorganic hard mask middle layer film and a four-layer resist process using an organic antireflective film or adhesion film in addition to these, and with such a patterning process of the present invention, it is possible to precisely transfer and form the circuit pattern of the resist upper layer film on the body to be processed.

Also, it is preferable that formation of the inorganic hard mask middle layer film is carried out by a CVD method or an ALD method.

In the patterning process of the present invention, for example, the inorganic hard mask middle layer film can be formed by such a method.

Also, it is preferable that, in formation of the circuit pattern, the circuit pattern is formed by lithography using light with a wavelength of 10 nm or more and 300 nm or less, direct drawing with electron beams, nanoimprinting, or a combination thereof.

Also, it is preferable that, in formation of the circuit pattern, the circuit pattern is developed by alkali development or an organic solvent.

In the patterning process of the present invention, such means of forming and developing the circuit pattern can be suitably used.

Also, it is preferable that the body to be processed is a semiconductor device substrate, or the semiconductor device substrate on which any of a metal film, a metal carbide film, a metal oxide film, a metal nitride film, a metal oxycarbide film, and a metal oxynitride film has been formed.

In this case, it is preferable to use as the body to be processed, one in which a metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

With the patterning process of the present invention, a pattern can be formed by processing the body to be processed as described above.

Furthermore, the present invention provides a polymer comprising a repeating unit represented by the following formula (B1): 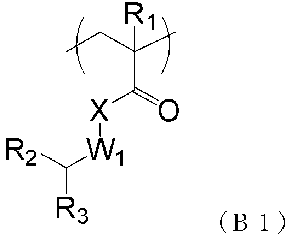 wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom.

Such a polymer can be a polymer in which the branched long chain alkyl group in the formula (B1) demonstrates a surfactant effect, making it suitable for forming an organic film that is excellent in in-plane uniformity and filling property and also suppresses the formation of humps caused by the remover in the EBR process.

In the present invention, it is preferable that W₁ in the formula (B1) is a group represented by the following formula (B2): 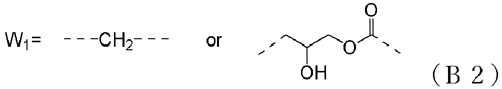 wherein broken lines represent a point of attachment to X and a point of attachment to the carbon atom to which R₂ and R₃ are bonded in the formula (B1), and W₁ has one of the structures represented by the formula (B2) or has two thereof.

A composition for forming an organic film comprising such a polymer can form an organic film that is more excellent in in-plane uniformity.

It is preferable that the polymer further comprises one of or two or more of repeating units represented by the following general formula (B3): 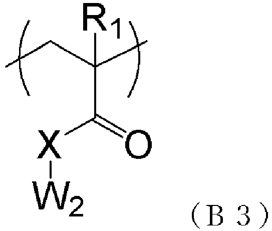 wherein R₁ and X are the same as described above, and W₂ is a monovalent organic group not containing fluorine atom and optionally containing an oxygen atom.

It is preferable to contain such a unit since solvent solubility can be enhanced.

In the present invention, it is preferable that W₂ in the formula (B3) is a group represented by the following formula (B4): 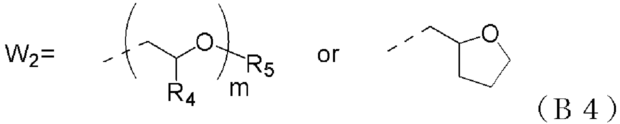 wherein R₄ is a hydrogen atom or a methyl group, R₅ is a hydrogen atom or a monovalent organic group having 1 to 10 carbon atoms and not containing fluorine atom, and m is an integer of 4 to 20.

It is preferable to contain such a unit since the thermal decomposability, surfactant effect, and flowability of the polymer can be adjusted, resulting in a compound that more reliably achieves both film formability and filling characteristic, etc., and furthermore, solubility in the resist solvent can be ensured.

It is preferable that the polymer has a weight average molecular weight of 1000 to 30000.

Such a range of weight average molecular weight makes it possible to form an organic film that is excellent in film formability and filling property. Note that the weight average molecular weight can be determined by the method described later.

### ADVANTAGEOUS EFFECTS OF INVENTION

As described above, according to the present invention, there can be provided a composition for forming an organic film that is excellent in film formability (in-plane uniformity) and filling property on a substrate (wafer), in film formability of a middle layer film on an organic film when used as an organic film, and in hump suppressing property during the EBR process, and a polymer contained therein. Since the composition for forming an organic film of the present invention is excellent in film formability and filling property, as well as suppressing property for humps generated during the EBR process, by using this composition for forming an organic film, it is possible to provide a patterning process that can be preferably applied to multilayer resist processes and the like, such as a two-layer resist process, a three-layer resist process using a silicon-containing resist middle layer film or inorganic hard mask middle layer film, or a four-layer resist process using a silicon-containing resist middle layer film or inorganic hard mask middle layer film, and an organic antireflective film or adhesion film. This patterning process is extremely useful as an organic film material or as an organic film forming material for semiconductor device manufacturing. In addition, the method for forming an organic film of the present invention can form organic films with suppressed humps, and can thus efficiently produce semiconductor elements and others. Also, the polymer of the present invention demonstrates the above properties by having a branched long chain alkyl group, which makes it more useful in compositions for forming an organic film.

### BRIEF DESCRIPTION OF DRAWINGS

FIG. 1 is an illustration of an example of the patterning process using the three-layer resist process of the present invention;
FIG. 2 is an example of a graph of hump height measured using a stylus profiler in Example 2;
FIG. 3 is an example of a graph of hump height measured using a stylus profiler in Comparative Example 2; and
FIG. 4 is an illustration of the filling property evaluation method in Examples.

### DESCRIPTION OF EMBODIMENTS

As mentioned above, there was a demand for the development of a composition for forming an organic film that is excellent in film formability (in-plane uniformity) and filling property on a substrate (wafer), and that can form an organic film with suppressed humps during the EBR process, a method for forming an organic film and a patterning process using this composition, and a polymer that can be used for the composition for forming an organic film.

Normally, when forming an organic film, a resin for forming an organic film and additives are dissolved in an organic solvent to form a composition, which is then applied with a coater and a developer onto a substrate on which structures, wiring, and other components have been formed, the substrate is rotated to spread the composition, the composition at the edge is removed in the EBR process, and then baked to form an organic film.

If the flowability of the above composition is insufficient, it is thought that voids are generated when filling holes and trenches with a very high aspect ratio, and it is also thought that humps are generated at the outer circumference of the organic film in the case where the resin for forming an organic film and additives have poor solubility in the remover used in the EBR process.

As a result of further diligent investigations on the above problems, the present inventors have found that, by blending a polymer having a specific repeating unit in a composition for forming an organic film, it is possible to provide a composition for forming an organic film that achieves both excellent film formability and a high degree of filling property, as well as excellent hump suppressing property in the EBR process, leading to the completion of the present invention.

That is, the present invention is a composition for forming an organic film, the composition comprising:
(A) a material for forming an organic film;
(B) a polymer having a repeating unit represented by the following formula (B1); and
(C) a solvent: 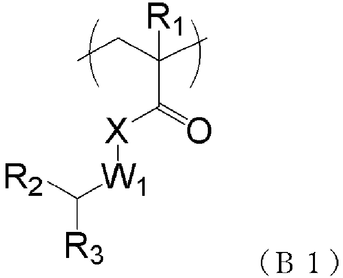
wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom.

The present invention is also a polymer comprising a repeating unit represented by the following formula (B1) : 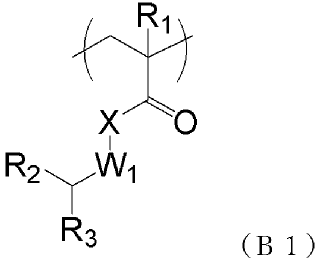 wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom.

Hereinafter, the present invention will be described in detail, but the present invention is not limited to the description below.

### [Composition for Forming Organic Film]

The composition for forming an organic film of the present invention comprises (A) a material for forming an organic film, (B) a polymer having a repeating unit represented by the following formula (B1), and (C) a solvent: 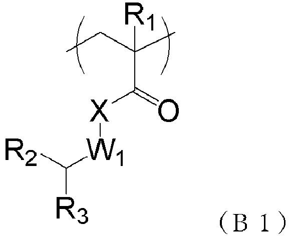 wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom.

Note that, in the composition for forming an organic film of the present invention, one kind of each of the (B) polymer, (A) material for forming an organic film, and (C) solvent can be used alone, or two or more kinds thereof can be used in combination.

Hereinafter, among the constituent components of the composition for forming an organic film described above, the (B) polymer, which is a feature of the present invention, will be described first, followed by the (A) material for forming an organic film and (C) solvent described above, and then other components.

### [(B) Polymer]

The (B) polymer of the present invention is a novel polymer having a repeating unit represented by the general formula (B1) that can be preferably used for a composition for forming an organic film. By blending this polymer into a composition for forming an organic film, a suitable composition for forming an organic film is provided.

The (B) polymer of the present invention is a compound containing a branched long chain alkyl group. A coating film formed by a composition for forming an organic film comprising the (A) material for forming an organic film, which will be described in a later section, and such a (B) polymer, is less likely to cause hump generation during the EBR process. In addition, by introducing an appropriate branched long chain alkyl group as in the formula (B1), it becomes possible to impart a function as a surfactant that has the ability to lower surface tension and provide excellent uniform coatability (leveling property) of the organic film. Therefore, in the case where the (B) polymer of the present invention is used as a surfactant, it can be used not only for organic films but also for coating materials for photolithography in general. Specific examples include photosensitive resist materials and materials for forming a top coat to be formed on the resist film. As described above, the (B) polymer of the present invention has the feature that it can function as a surfactant.

That is, according to the composition for forming an organic film of the present invention, which comprises the (A) material for forming an organic film and the (B) polymer, it is possible to form an organic film that is excellent in film formability and filling property on the substrate, and excellent in hump suppressing property during the EBR process, as well as being excellent in process tolerance when used as an organic film for a multilayer resist. For example, by using the composition for forming an organic film of the present invention, it is possible to form an organic film that is excellent for a multilayer resist for microfabrication in the manufacture of a semiconductor device or the like, or an organic film that is excellent for planarization in the manufacture of a semiconductor device or the like.

In the general formula (B1), R₁ is a hydrogen atom or a methyl group. R₂ and R₃ are each independently a monovalent organic group having 10 to 20 carbon atoms and not containing fluorine atom, and examples of the monovalent organic group include a decyl group, an undecyl group, a dodecyl group, a tridecyl group, a tetradecyl group, a pentadecyl group, a hexadecyl group, a heptadecyl group, an octadecyl group, a nonadecyl group, and an icosyl group.

R₂ and R₃ are preferably a decyl group, a dodecyl group, or a hexadecyl group from the viewpoint of raw material availability.

In the formula (B1), X is a nitrogen atom or an oxygen atom. W₁ is a single bond or a divalent linking group having 1 to 10 carbon atoms and not containing fluorine atom and optionally containing an oxygen atom, and when W₁ is a divalent organic group having 1 to 10 carbon atoms and not containing fluorine atom and optionally containing an oxygen atom, examples of the divalent organic group include a methylene group, an ethanediyl group, a propanediyl group, a butanediyl group, a pentanediyl group, a hexanediyl group, a heptanediyl group, an octanediyl group, a nonanediyl group, a decanediyl group, and a divalent organic group optionally containing an oxygen atom, a carbonyl group, and/or an ester group.

In the (B) polymer of the present invention, it is preferable that W₁ in the formula (B1) is a group represented by the following formula (B2): 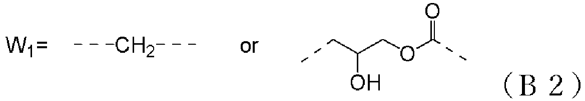 wherein broken lines represent a point of attachment to X and a point of attachment to the carbon atom to which R₂ and R₃ are bonded in the formula (B1), and W₁ has one of the structures represented by the formula (B2) or has two thereof.

With a composition for forming an organic film comprising such a polymer, the branched long chain alkyl group can demonstrate a surfactant effect, which thus improves the film formability during application, and the decomposition products generated during baking do not impair the in-plane uniformity of the film, and there is no formation of insoluble matter due to reactions between decomposition products. Therefore, in the case where it is used as an organic film, process tolerance is not narrowed, and there is no occurrence of device contamination or inconvenience, etc.

It is preferable that the polymer (B) further comprises one of or two or more of repeating units represented by the following general formula (B3): 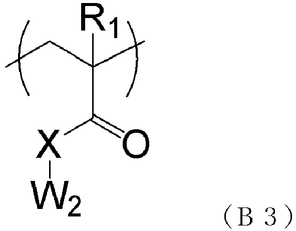 wherein R₁ and X are the same as described above, and W₂ is a monovalent organic group not containing fluorine atom and optionally containing an oxygen atom.

In the formula (B3), X is preferably an oxygen atom.

Specific examples of the formula (B3) include, but are not limited to, those listed below.

In the following examples, R₁ is a hydrogen atom or a methyl group, R₅ is a hydrogen atom or a monovalent organic group having 1 to 10 carbon atoms and not containing fluorine atom, and m is an integer of 4 to 20.

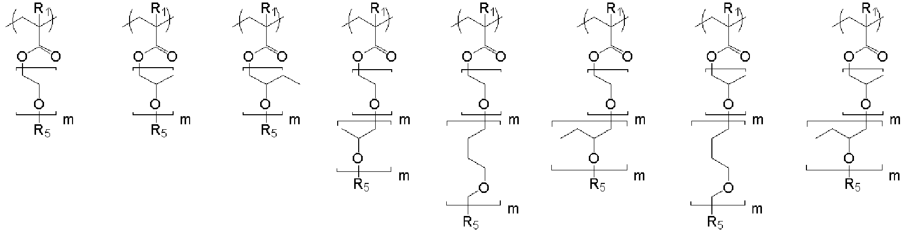

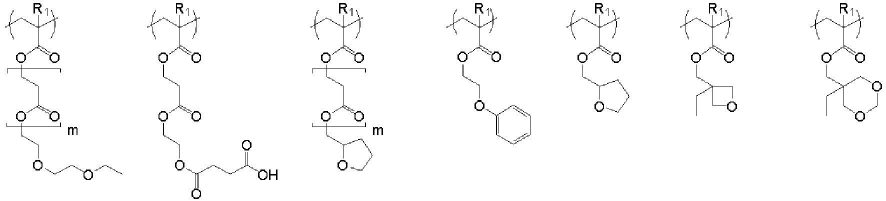

By containing such a unit, solvent solubility can be enhanced.

In the (B) polymer of the present invention, it is preferable that W₂ in the formula (B3) is a group represented by the following formula (B4): 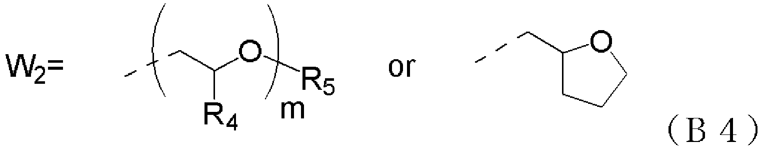 wherein R₄ is a hydrogen atom or a methyl group, R₅ is a hydrogen atom or a monovalent organic group having 1 to 10 carbon atoms and not containing fluorine atom, and m is an integer of 4 to 20.

Further preferable specific examples of the formula (B3) include, but are not limited to, those listed below. In the following examples, R₁ is a hydrogen atom or a methyl group.

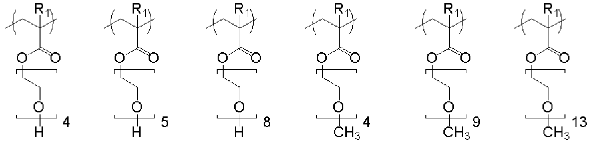

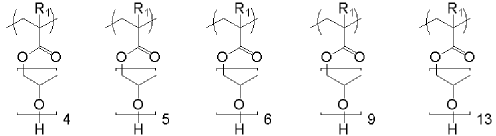

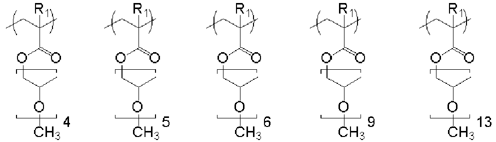

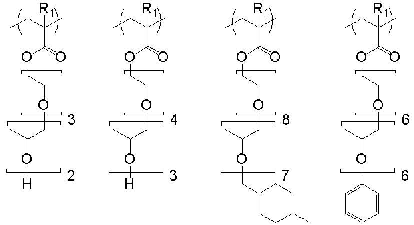

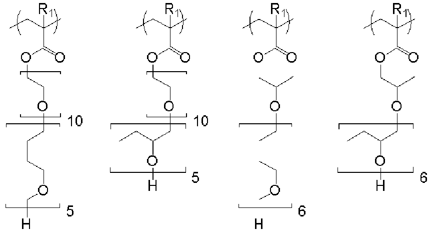

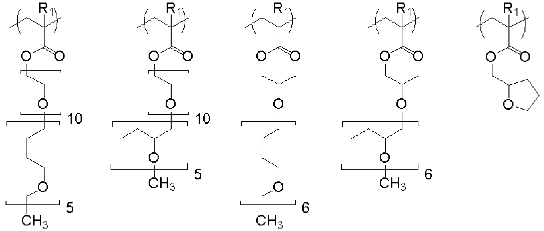

By containing such a unit, the thermal decomposability, surfactant effect, and flowability of the polymer can be adjusted, and a compound that more reliably achieves a both film-forming property and filling property, and further solubility in a resist solvent can be ensured.

The weight average molecular weight of the (B) polymer is preferably 1,000 to 30,000, and more preferably 1,500 to 25,000. When the weight average molecular weight is 1,000 or more, a decrease in the blending effect due to volatilization, etc. can be suppressed and a sufficient blending effect can be obtained. Also, when the weight average molecular weight is 30,000 or less, there is no degradation of flowability, etc., resulting in excellent filling property.

Also, as for the amount of the component (B) added, it is preferable that the content of the component (B) is 0.01 parts by mass to 5 parts by mass based on 100 parts by mass of the content of the (A) material for forming an organic film.

Note that in the present invention, the weight average molecular weight (Mw) and number average molecular weight (Mn) are values in terms of polystyrene by gel permeation chromatography (GPC) using tetrahydrofuran as the eluent (solvent) under the condition where the measurement temperature is 40°C, and the dispersity (Mw/Mn) is determined from the Mw and Mn.

### [Method for Producing (B) Polymer]

The means of obtaining the (B) polymer of the present invention is not limited, but for example, as shown below, it can be synthesized by (1) in the case where the branched long chain alkyl unit is introduced from a (meth)acrylic monomer; a method in which (meth)acryl or (meth)acrylamide is synthesized by radical polymerization or the like, or (2) in the case where the branched long chain alkyl unit is introduced by post-modification; a method in which a carboxylic acid is allowed to act on an epoxy-containing polymer obtained by radical polymerization. One kind of (meth)acryl or (meth)acrylamide can be used alone, or two or more kinds thereof can be used in the synthesis. These can be selected and combined as appropriate depending on the required properties. R₁, R₂, R₃, X, W₁, and W₂ in the following formula are the same as described above.
(1) In the case where the branched long chain alkyl unit is introduced from a (meth)acrylic monomer 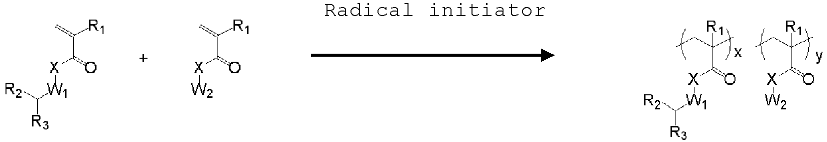
(2) In the case where the branched long chain alkyl unit is introduced by post-modification

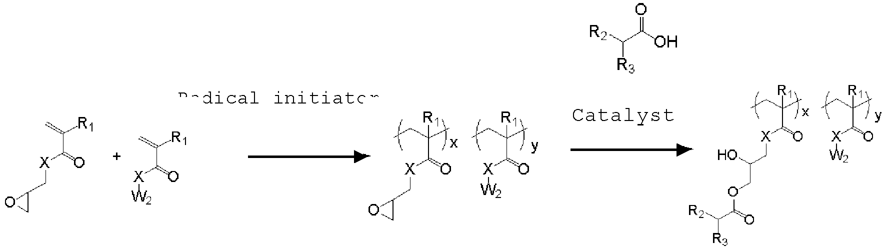

Examples of the radical initiator to be used at this time include 2,2'-azobisisobutyronitrile (AIBN), 2,2'-azobis(2,4-dimethylvaleronitrile), dimethyl 2,2-azobis(2-methylpropionate), 1,1'-azobis(1-acetoxy-1-phenylethane), benzoyl peroxide, and lauroyl peroxide, and one kind of these may be used alone, or two or more kinds thereof may be used in combination. It is preferable that the amount of these radical initiators added is 0.01 to 25 mol% based on the total of the monomers allowed to react.

The solvent to be used at this time is not particularly restricted as long as it is a solvent that is inert to the above reaction. Examples thereof include ether solvents such as diethyl ether, tetrahydrofuran, and dioxane, aromatic solvents such as benzene, toluene, and xylene, and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate, and one of these can be used alone or a mixture thereof can be used. These solvents can be used, for example, in the range of 0 to 2000 parts by mass based on 100 parts by mass of the reaction raw materials, and the reaction temperature is preferably 50 to 150°C, and more preferably 60 to 100°C. The reaction time is selected as appropriate from 0.1 to 100 hours.

The reaction method includes the following: a method in which (meth)acryl or (meth)acrylamide is charged in a solvent at once; a method in which each of (meth)acryl or (meth)acrylamide is dispersed or dissolved in a different solvent, and these are charged by dropwise addition; and a method in which either (meth)acryl or (meth)acrylamide is dispersed or dissolved in a solvent, and then the other is dispersed or dissolved in a solvent, which is charged thereto by dropwise addition. Also, in the case where several kinds of (meth)acryl or (meth)acrylamide are each charged, they can be mixed and allowed to react in advance, or they can be allowed to react separately and sequentially. In the case where a radical initiator is used, the following methods can be used: a method in which the radical initiator is charged with (meth)acryl or (meth)acrylamide at once, a method in which the radical initiator is added or dropped after (meth)acryl or (meth)acrylamide is dispersed or dissolved in a solvent, and a method in which the radical initiator is dispersed or dissolved in advance, to which (meth)acryl or (meth)acrylamide is added dropwise, etc.

(2) In the case where the branched long chain alkyl unit is introduced by post-modification, as for the amount ratio between the above epoxy compound and carboxylic acid compound, the amount of carboxyl group in the carboxylic acid compound is preferably 0.3 to 2.0 moles, more preferably 0.5 to 1.5 moles, and still more preferably 0.75 to 1.25 moles based on 1 mole of epoxy group in the epoxy compound. If the amount of carboxyl group based on the amount of epoxy group is moderate as described above, there is no risk that unreacted epoxy groups remain to impair the storage stability of the composition for forming an organic film, and the carboxylic acid compound can be prevented from remaining unreacted and causing outgassing.

The compound synthesized by introducing the above branched long chain alkyl unit of the present invention by post-modification can normally be obtained by allowing the epoxy compound to react with the carboxylic acid compound at room temperature or under cooling or heating as necessary in the presence of a reaction catalyst with no solvent or in a solvent.

Specific examples of the solvent to be used at this time can include alcohols such as methanol, ethanol, isopropyl alcohol, butanol, ethylene glycol, propylene glycol, diethylene glycol, glycerol, methyl cellosolve, ethyl cellosolve, butyl cellosolve, and propylene glycol monomethyl ether; ethers such as diethyl ether, dibutyl ether, diethylene glycol diethyl ether, diethylene glycol dimethyl ether, tetrahydrofuran, and 1,4-dioxane; chlorinated solvents such as methylene chloride, chloroform, dichloroethane, and trichloroethylene; hydrocarbons such as hexane, heptane, benzene, toluene, xylene, and cumene; nitriles such as acetonitrile; ketones such as acetone, ethyl methyl ketone, and isobutyl methyl ketone; esters such as ethyl acetate, n-butyl acetate, and propylene glycol methyl ether acetate; lactones such as γ-butyrolactone; and non-protic polar solvents such as dimethyl sulfoxide, N,N-dimethylformamide, and hexamethylphosphoric triamide. One kind of these can be used alone, or two or more kinds thereof can be mixed for use. These solvents are preferably used in the range of 0 to 2,000 parts by mass based on 100 parts by mass of the reaction raw materials.

A catalyst may be used in the reaction of introducing the branched long chain alkyl unit by post-modification. Specific examples of the catalyst include quaternary ammonium salts such as benzyltriethylammonium chloride, benzyltriethylammonium bromide, benzyltrimethylammonium chloride, tetramethylammonium chloride, tetramethylammonium bromide, tetramethylammonium iodide, tetramethylammonium hydroxide, tetraethylammonium bromide, tetrabutylammonium chloride, tetrabutylammonium bromide, tetrabutylammonium iodide, tetrabutylammonium hydrogen sulfate, trioctylmethylammonium chloride, tributylbenzylammonium chloride, trimethylbenzylammonium chloride, trimethylbenzylammonium hydroxide, N-laurylpyridinium chloride, N-lauryl-4-picolinium chloride, N-laurylpicolinium chloride, trimethylphenylammonium bromide, and N-benzylpicolinium chloride; quaternary phosphonium salts such as tetrabutylphosphonium chloride, tetrabutylphosphonium bromide, and tetraphenylphosphonium chloride; and tertiary amines such as tris[2-(2-methoxyethoxy)ethyl]amine, tris(3,6-dioxaheptyl)amine, and tris(3,6-dioxaoctyl)amine. The amount of the catalyst used is preferably in the range of 0.001 to 100% by mass, and more preferably in the range of 0.005 to 50% by mass, based on the raw materials. The reaction temperature is preferably -50°C to about the boiling point of the solvent, and still more preferably room temperature to 150°C. The reaction time is selected as appropriate from 0.1 to 100 hours.

Examples of the method for the reaction of introducing the branched long chain alkyl unit by post-modification include a method in which the epoxy compound, carboxylic acid compound, and catalyst are charged at once, a method in which the epoxy compound and carboxylic acid compound are dispersed or dissolved in a solvent, and the catalyst is then added at once or diluted with a solvent and added dropwise, and a method in which the catalyst is dispersed or dissolved in a solvent, and the epoxy compound and carboxylic acid compound are then added at once or diluted with a solvent and added dropwise. After completion of the reaction, the reaction product may be used as it is as the composition for forming an organic film, but it may also be diluted in an organic solvent, on which liquid separation and washing is then performed to remove the unreacted raw materials, catalyst, etc. present in the system, and to recover the product.

In order to remove the unreacted raw materials, catalyst, etc. present in the system, the reaction solution obtained by the method described above by means of examples can also be diluted in an organic solvent, on which liquid separation and washing is then performed to recover the (B) polymer.

The organic solvent used in the liquid separation and washing is not particularly restricted as long as it is capable of dissolving the compound and is separated into two layers when mixed with water, but examples thereof may include hydrocarbons such as hexane, heptane, benzene, toluene, and xylene; esters such as ethyl acetate, n-butyl acetate, and propylene glycol methyl ether acetate; ketones such as methyl ethyl ketone, methyl amyl ketone, cyclohexanone, and methyl isobutyl ketone; ethers such as diethyl ether, diisopropyl ether, methyl tert-butyl ether, and ethylcyclopentyl methyl ether; chlorinated solvents such as methylene chloride, chloroform, dichloroethane, and trichloroethylene; and a mixture thereof. As the water used for washing at this time, normally, what is called deionized water or ultrapure water may be used. The washing is carried out at least once, but since sufficient washing effect may not be obtained even if washing is carried out 10 times or more, it is preferable to wash the substrate 1 to 5 times.

In the liquid separation and washing, the washing may be performed with a basic aqueous solution in order to remove the unreacted raw materials or acidic components in the system. Specific examples of the base include hydroxides of alkali metals, carbonates of alkali metals, hydroxides of alkaline earth metals, carbonates of alkaline earth metals, ammonia, and organic ammonium.

Furthermore, in the liquid separation and washing, the washing may be performed with an acidic aqueous solution in order to remove the unreacted raw materials, metal impurities, or basic components in the system. Specific examples of the acid include inorganic acids such as hydrochloric acid, hydrobromic acid, sulfuric acid, nitric acid, phosphoric acid, and heteropoly acid; and organic acids such as oxalic acid, fumaric acid, maleic acid, trifluoroacetic acid, methanesulfonic acid, benzenesulfonic acid, p-toluenesulfonic acid, and trifluoromethanesulfonic acid.

The liquid separation and washing may be performed with any one of the above basic aqueous solution and acidic aqueous solution, or can be performed with a combination of the two. The liquid separation and washing is preferably performed with the basic aqueous solution and the acidic aqueous solution in this order from the viewpoint of removing the metal impurities.

After the liquid separation and washing with the above basic aqueous solution and/or acidic aqueous solution, washing with neutral water may be successively performed. As the neutral water, deionized water, ultrapure water, or the like as mentioned above may be used. The washing is carried out at least once, but if the washing is not less frequent, the basic components and the acidic components may not be removed in some cases. since sufficient washing effect may not be obtained even if washing is carried out 10 times or more, it is preferable to wash the substrate 1 to 5 times.
The washing is performed preferably about once to five times since washing ten or more times does not always produce the full washing effect thereof.

Furthermore, the reaction product after the liquid separation operation can also be recovered as a powder by concentrating and drying the solvent or crystallizing the reaction product under reduced pressure or normal pressure. Alternatively, the reaction product can be retained in a solution state with an appropriate concentration to improve the workability in preparing the polymer having the branched long chain alkyl unit introduced by post-modification. The concentration at this time is preferably 0.1 to 50% by mass, and more preferably 0.5 to 30% by mass. With such a concentration, the viscosity is hardly increased, making it possible to prevent degradation of the workability; in addition, since the amount of the solvent is not excessive, the solution can be prepared economically.

The solvent at this time is not particularly restricted as long as it is capable of dissolving the compound, but specific examples thereof include ketones such as cyclohexanone and methyl 2-amyl ketone; alcohols such as 3-methoxybutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One kind of these can be used alone, or two or more kinds thereof can be mixed for use.

### [(A) Material for Forming Organic Film]

The (A) material for forming an organic film (resin or compound) to be used in the composition for forming an organic film of the present invention is not particularly limited as long as it is a resin or compound that satisfies film formability and curability for spin coating. However, from the viewpoints of etching resistance, optical properties, heat resistance, etc., a resin or compound that contains an aromatic skeleton (different from the (B) polymer) is more preferable.

Examples of the above aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, and carbazole. Among these, benzene, naphthalene, fluorene, and carbazole are particularly preferable.

The above (A) material for forming an organic film will be described below by means of specific examples, but they are merely examples and the material is not limited to them. Also, the formula numbers shown in the examples below apply only for the purpose of describing the formulae below.

As the (A) material for forming an organic film (resin or compound) to be used in the present invention, resins and the like including the following structures as described in JP 2012-001687 A and JP 2012-077295 A can be exemplified. 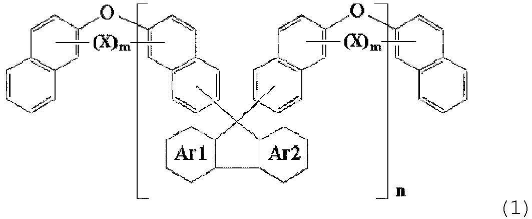 (In the formula (1), the ring structures Ar1 and Ar2 each independently represent a benzene ring or a naphthalene ring. X represents a single bond or an alkylene group having 1 to 20 carbon atoms. m represents 0 or 1. n represents an arbitrary natural number such that the molecular weight is 100,000 or less. Note that the definitions of symbols in the formula apply only in this formula.) 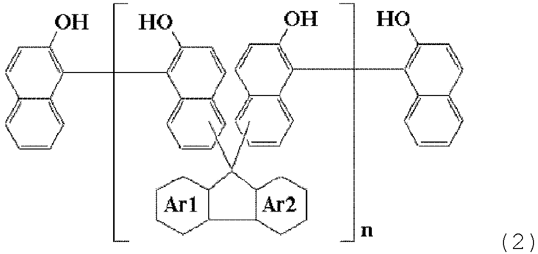 (In the formula (2), the ring structures Ar1 and Ar2 each independently represent a benzene ring or a naphthalene ring. n represents an arbitrary natural number such that the weight average molecular weight in terms of polystyrene by gel permeation chromatography is 100,000 or less. Note that the definitions of symbols in the formula apply only in this formula.)

As the (A) material for forming an organic film to be used in the present invention, resins and the like including the following structures as described in JP 2004-264710 A, JP 2005-043471 A, JP 2005-250434 A, JP 2007-293294 A, and JP 2008-065303 A can be further exemplified. 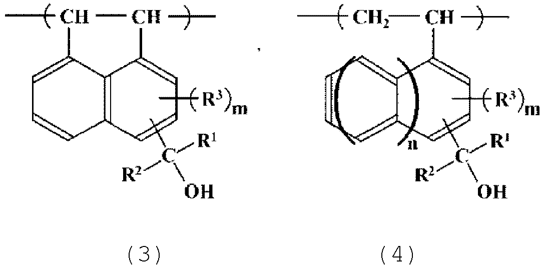 (In the formula (3) and the formula (4), R¹ and R² each independently represent a hydrogen atom, or an alkyl group having 1 to 3 carbon atoms or an aryl group; R³ represents an alkyl group having 1 to 3 carbon atoms, a vinyl group, an allyl group, or an optionally substituted aryl group; n represents 0 or 1; and m represents 0, 1, or 2. Note that the definitions of symbols in the formula apply only in this formula.) 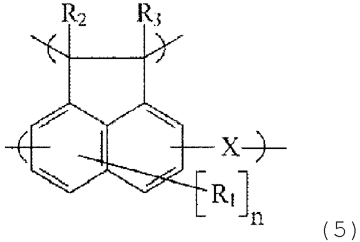 (In the formula (5), R₁ is a monovalent atom or group other than hydrogen atom, and n is an integer of 0 to 4. However, when n is 2 to 4, a plurality of R₁ may be the same or different. R₂ and R₃ are each independently a monovalent atom or group. X is a divalent group. Note that the definitions of symbols in the formula apply only in this formula.) 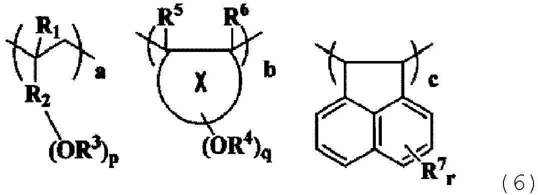 (In the formula (6), R₁ is a hydrogen atom or a methyl group. R₂ is any of a single bond, a linear, branched, or cyclic alkylene group having 1 to 20 carbon atoms, and an arylene group having 6 to 10 carbon atoms, and may have any of ether, ester, lactone, and amide. R³ and R⁴ are each independently a hydrogen atom or a glycidyl group. X is a polymer of any of a hydrocarbon including an indene skeleton, a cycloolefin having 3 to 10 carbon atoms, and a maleimide, and may have any of ether, ester, lactone, and carboxylic anhydride. R⁵ and R⁶ are each independently any of a hydrogen atom, a fluorine atom, a methyl group, and a trifluoromethyl group. R⁷ is any of a hydrogen atom, a linear, branched, or cyclic alkyl group having 1 to 6 carbon atoms, a hydroxy group, and an alkoxycarbonyl group. p and q are each an integer of 1 to 4. r is an integer of 0 to 4. a, b, and c are each in the range of 0.5 ≤ a + b + c ≤ 1, 0 ≤ a ≤ 0.8, 0 ≤ b ≤ 0.8, 0.1 ≤ a + b ≤ 0.8, and 0.1 ≤ c ≤ 0.8. Note that the definitions of symbols in the formula apply only in this formula.) 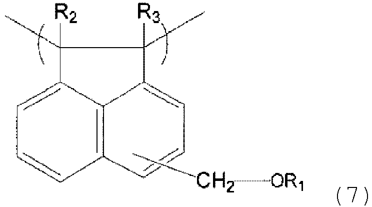 (In the formula (7), R₁ represents a hydrogen atom or a monovalent organic group, and R₂ and R₃ each independently represent a monovalent atom or a monovalent organic group. Note that the definitions of symbols in the formula apply only in this formula.)

As the (A) material for forming an organic film to be used in the present invention, specifically, resins and the like including the following structures as described in JP 2004-205685 A, JP 2007-171895 A, and JP 2009-014816 A can be further exemplified. 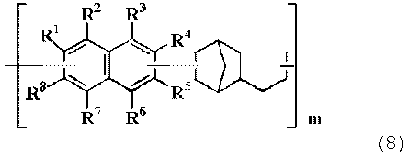 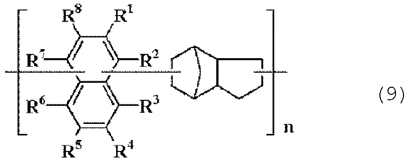 (In the formula (8) and the formula (9), R¹ to R⁸ are each independently a hydrogen atom, a hydroxy group, a substitutable alkyl group having 1 to 6 carbon atoms, a substitutable alkoxy group having 1 to 6 carbon atoms, a substitutable alkoxycarboxyl group having 2 to 6 carbon atoms, a substitutable aryl group having 6 to 10 carbon atoms, a hydroxyalkyl group having 1 to 6 carbon atoms, an isocyanate group, or a glycidyl group. m and n are positive integers. Note that the definitions of symbols in the formula apply only in this formula.) 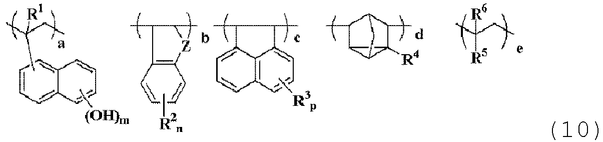 (In the formula (10), R¹ and R⁶ are each independently a hydrogen atom or a methyl group. R², R³, and R⁴ are each independently a hydrogen atom, an alkyl group having 1 to 4 carbon atoms, an alkoxy group, a hydroxy group, an acetoxy group or an alkoxycarbonyl group, or an aryl group having 6 to 10 carbon atoms; R⁵ is a fused polycyclic hydrocarbon group having 13 to 30 carbon atoms, -O-R7, -C(=O)-O-R⁷, -O-C(=O)-R⁷, or -C(=O)-NR⁸-R⁷; m is 1 or 2; n is an integer of 0 to 4; and p is an integer of 0 to 6. R⁷ is an organic group having 7 to 30 carbon atoms, and R⁸ is a hydrogen atom or a hydrocarbon group having 1 to 6 carbon atoms. Z is any of a methylene group, -O-, -S-, and -NH-. a, b, c, d, and e are each in the range of 0 < a < 1.0, 0 ≤ b ≤ 0.8, 0 ≤ c ≤ 0.8, 0 ≤ d ≤ 0.8, 0 ≤ e ≤ 0.8, and 0 < b + c + d + e < 1.0. Note that the definitions of symbols in the formula apply only in this formula.) 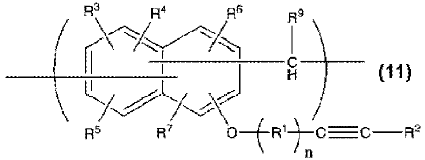 (In the formula (11), n represents 0 or 1. R¹ represents an optionally substituted methylene group, an optionally substituted alkylene group having 2 to 20 carbon atoms, or an optionally substituted arylene group having 6 to 20 carbon atoms. R² represents a hydrogen atom, an optionally substituted alkyl group having 1 to 20 carbon atoms, or an optionally substituted aryl group having 6 to 20 carbon atoms. R³ to R⁷ each independently represent a hydroxy group, an optionally substituted alkyl group having 1 to 6 carbon atoms, an optionally substituted alkoxy group having 1 to 6 carbon atoms, an optionally substituted alkoxycarbonyl group having 2 to 10 carbon atoms, an optionally substituted aryl group having 6 to 14 carbon atoms, or an optionally substituted glycidyl ether group having 2 to 6 carbon atoms. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the definitions of symbols in the formula apply only in this formula.)

As the resin represented by the formula (11), for example, the following resins are exemplified.

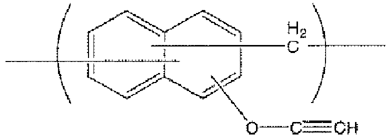

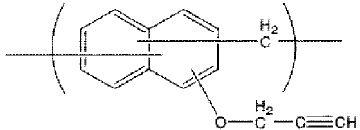

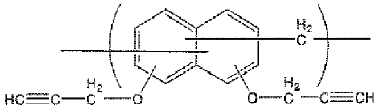

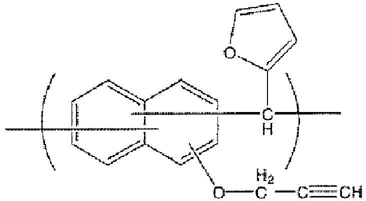

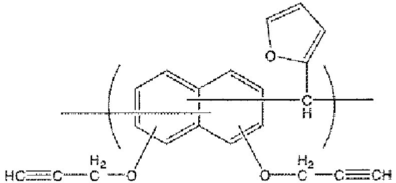

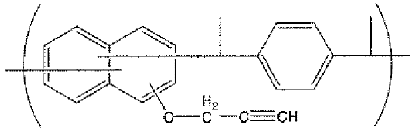

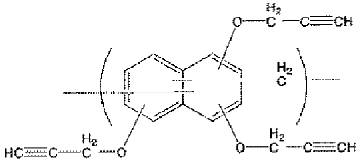

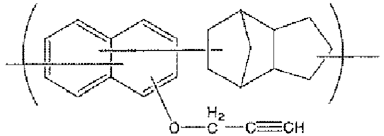

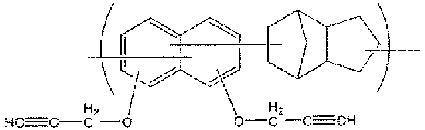

As the (A) material for forming an organic film to be used in the present invention, resins and the like including the following structures as described in JP 2007-199653 A, JP 2008-274250 A, and JP 2010-122656 A can be further exemplified. 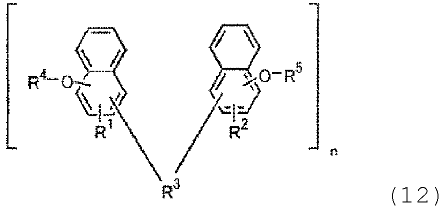 (In the formula (12), R¹ and R² are the same or different, and are each independently a hydrogen atom, a linear, branched, or cyclic alkyl group having 1 to 10 carbon atoms, an aryl group having 6 to 10 carbon atoms, or an alkenyl group having 2 to 10 carbon atoms; R³ is a single bond, or an alkylene group having 1 to 30 carbon atoms, having a linear, branched, or cyclic structure, and optionally having a bridged cyclic hydrocarbon group, a double bond, a heteroatom, or an aromatic group having 6 to 30 carbon atoms; R⁴ and R⁵ are each independently a hydrogen atom or a glycidyl group; and n is an integer of 1 to 4. Note that the definitions of symbols in the formula apply only in this formula.) 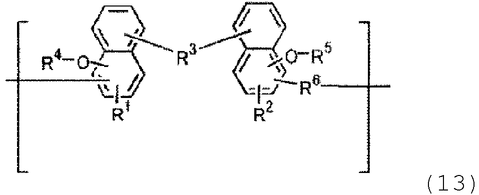 (In the formula (13), R¹ and R² are the same or different, and are each independently a hydrogen atom, a linear, branched, or cyclic alkyl group having 1 to 10 carbon atoms, an aryl group having 6 to 10 carbon atoms, or an alkenyl group having 2 to 10 carbon atoms; R³ is a single bond, or an alkylene group having 1 to 30 carbon atoms, having a linear, branched, or cyclic structure, and optionally having a bridged cyclic hydrocarbon group, a double bond, a heteroatom, or an aromatic group having 6 to 30 carbon atoms; R⁴ and R⁵ are each independently a hydrogen atom or a glycidyl group; and R⁶ is a single bond, or a linear or branched alkylene group having 1 to 10 carbon atoms. Note that the definitions of symbols in the formula apply only in this formula.) 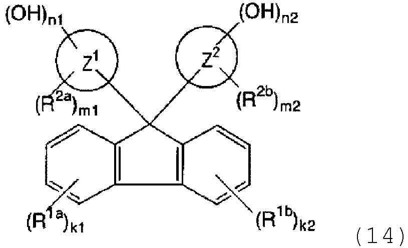 (In the formula (14), the ring Z¹ and the ring Z² are fused polycyclic aromatic hydrocarbon rings, and R^{1a}, R^{1b}, R^{2a}, and R^{2b} represent substituents that may be the same or different. k1 and k2 may be the same or different and represent 0 or an integer of 1 to 4; m1 and m2 each represent 0 or an integer of 1 or more; and n1 and n2 each represent 0 or an integer of 1 or more. However, n1 + n2 ≥ 1. Note that the definitions of symbols in the formula apply only in this formula.) 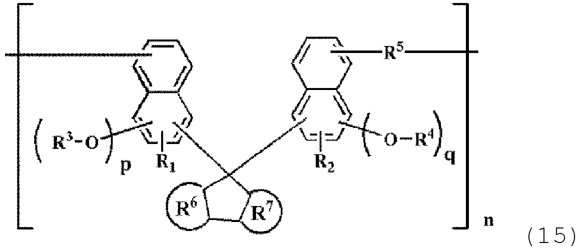 (In the formula (15), R₁ and R₂ are the same or different, and are a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ are each independently a hydrogen atom or a glycidyl group; R⁵ is a single bond, or a linear or branched alkylene group having 1 to 10 carbon atoms; and R⁶ and R⁷ are each independently a benzene ring or a naphthalene ring. p and q are each 1 or 2. n is 0 < n ≤ 1. Note that the definitions of symbols in the formula apply only in this formula.)

As the resin represented by the formula (15), for example, the following resins are exemplified.

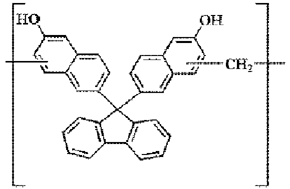

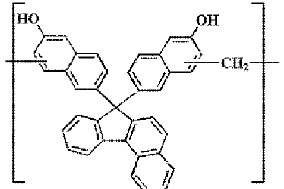

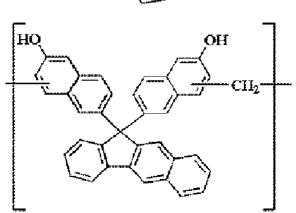

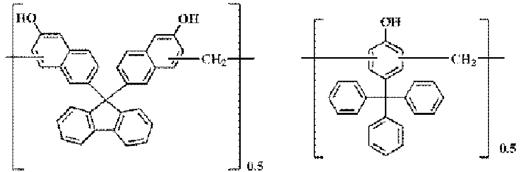

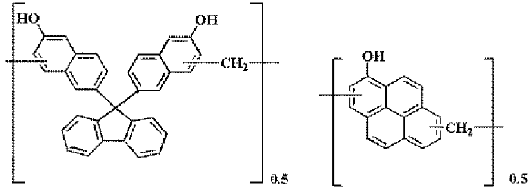

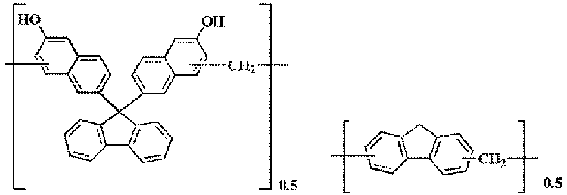

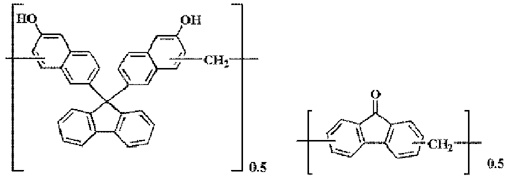

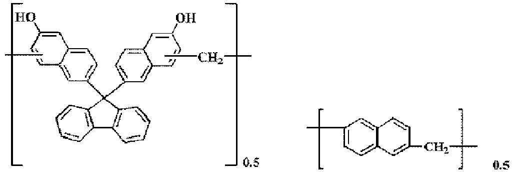

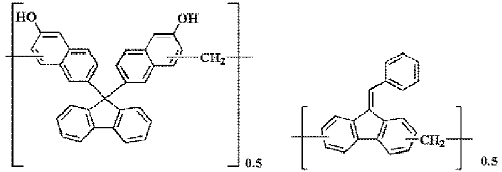

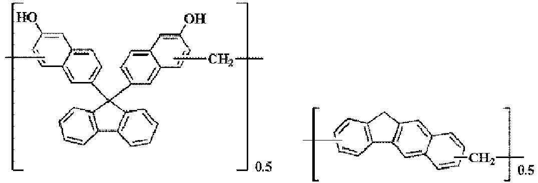

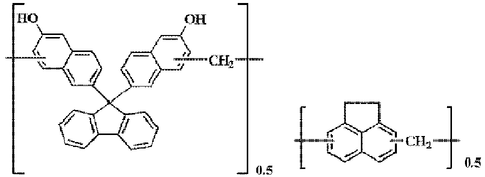

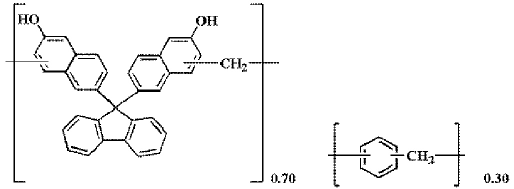

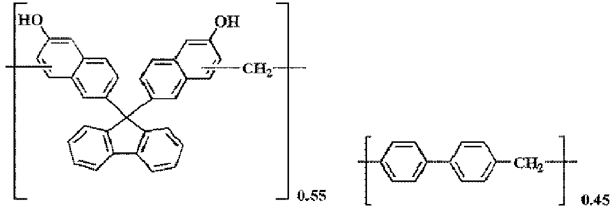

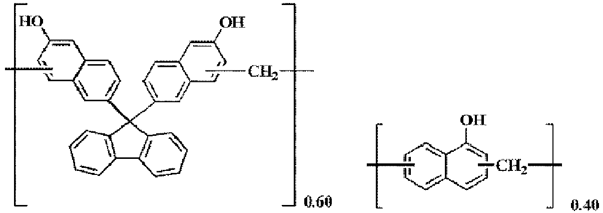

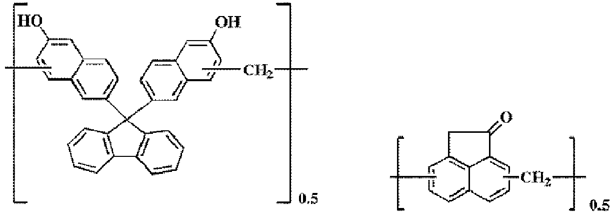

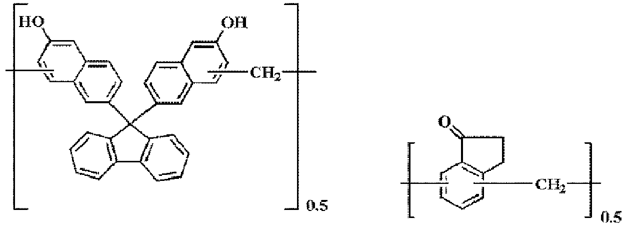

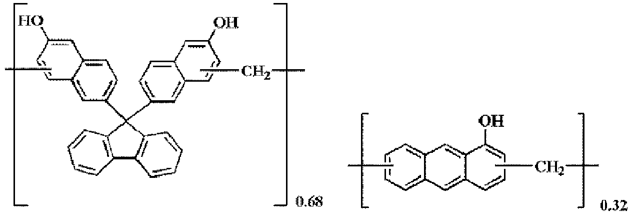

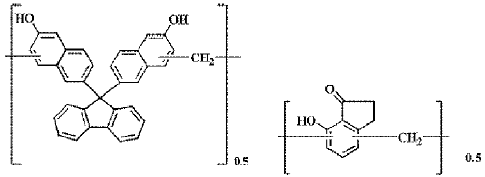

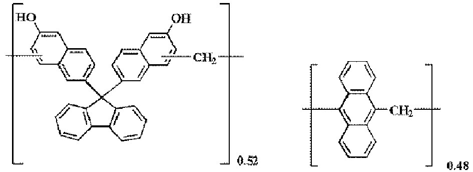

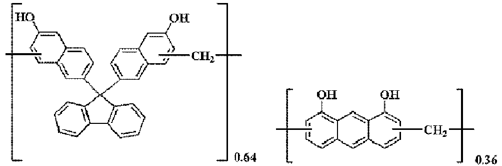

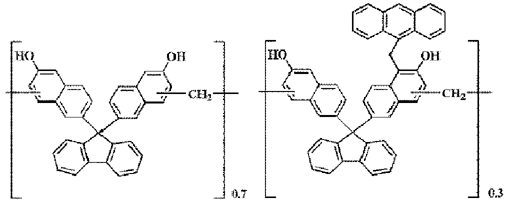

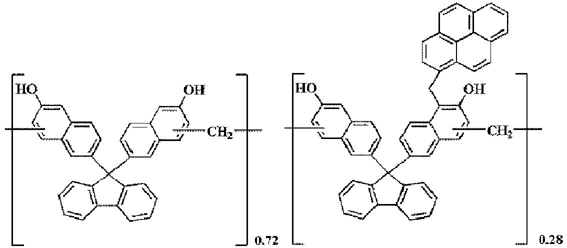

As the (A) material for forming an organic film to be used in the present invention, resins and the like including the following structure as described in JP 2012-214720 A can be further exemplified. 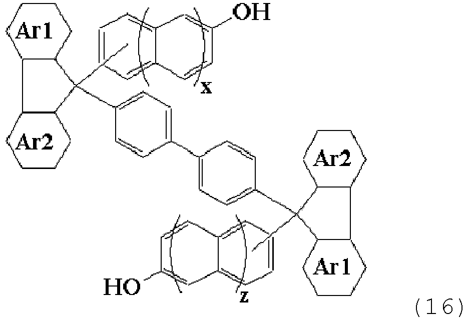 (In the formula (16), the ring structures Ar1 and Ar2 each independently represent a benzene ring or a naphthalene ring. x and z each independently represent 0 or 1. Note that the definitions of symbols in the formula apply only in this formula.)

As the (A) material for forming an organic film to be used in the present invention, resins and the like as described in JP 2014-29435 A can be further exemplified. 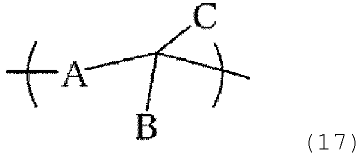 (In the formula (17), A represents a structure having carbazole; B represents a structure having an aromatic ring; C represents a hydrogen atom, an alkyl group, or a structure having an aromatic ring; and B and C may constitute a ring with each other. In the structure where A, B, and C are combined, 1 to 4 carboxyl groups or salts thereof, or carboxylic acid ester groups are present. Note that the definitions of symbols in the formula apply only in this formula.)

Also, as the (A) material for forming an organic film to be used in the present invention, polymers containing the unit structure represented by the following formula (18) and the unit structure represented by the following formula (19), in which the proportions of the unit structure represented by the formula (18) and the unit structure represented by the formula (19) are 3 to 97:97 to 3 in molar ratio, as described in WO 2012/077640 A1 can be further exemplified. 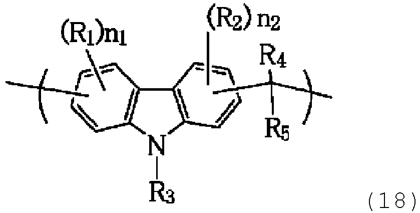 (In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of these groups optionally containing an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of these groups optionally containing an ether bond, a ketone bond, or an ester bond. R₄ represents a hydrogen atom, or an aryl group having 6 to 40 carbon atoms optionally substituted with a halogen atom, a nitro group, an amino group or a hydroxy group, or heterocyclic group optionally substituted with a halogen atom, a nitro group, an amino group or a hydroxy group; R₅ represents a hydrogen atom, or an alkyl group having 1 to 10 carbon atoms optionally substituted with a halogen atom, a nitro group, an amino group or a hydroxy group, or aryl group having 6 to 40 carbon atoms optionally substituted with a halogen atom, a nitro group, an amino group or a hydroxy group, or heterocyclic group optionally substituted with a halogen atom, a nitro group, an amino group or a hydroxy group; and R₄ and R₅ may form a ring with each other. n1 and n2 each represent an integer of 1 to 3. Note that the definitions of symbols in the formula apply only in this formula.) 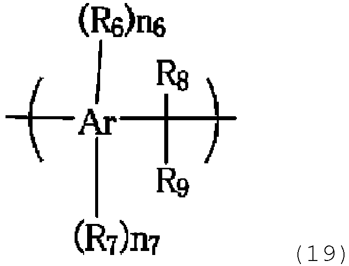 (In the formula (19), Ar represents an aromatic ring group having 6 to 20 carbon atoms; R₆ represents a hydroxy group; and R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of these groups optionally containing an ether bond, a ketone bond, or an ester bond. R₈ represents a hydrogen atom, or an aryl group having 6 to 40 carbon atoms optionally substituted with a halogen atom, a nitro group, an amino group or a hydroxy group, or heterocyclic group optionally substituted with a halogen atom, a nitro group, an amino group or a hydroxy group; R₉ represents a hydrogen atom, or an alkyl group having 1 to 10 carbon atoms optionally substituted with a halogen atom, a nitro group, an amino group or a hydroxy group, or aryl group having 6 to 40 carbon atoms optionally substituted with a halogen atom, a nitro group, an amino group or a hydroxy group, or heterocyclic group optionally substituted with a halogen atom, a nitro group, an amino group or a hydroxy group; and R₈ and R₉ may form a ring with each other. n6 represents an integer of 1 to p, and n7 represents an integer of p - n6. Here, p represents the maximum number of substitutions that can be made in the aromatic ring group Ar. Note that the definitions of symbols in the formula apply only in this formula.)

As the (A) material for forming an organic film to be used in the present invention, polymers containing the unit structure represented by the following formula (20), as described in WO 2010/147155 A1 can be further exemplified. 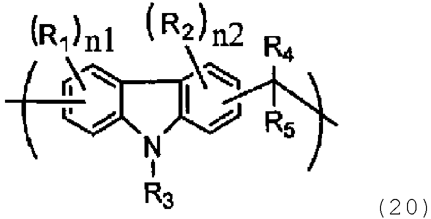 (In the formula (20), R₁ and R₂ each independently represent a group selected from the group consisting of a hydrogen atom, a halogen group, a nitro group, an amino group, a hydroxy group, an alkyl group having 1 to 10 carbon atoms, an alkenyl group having 2 to 10 carbon atoms, an aryl group having 6 to 40 carbon atoms, and combinations thereof, wherein the alkyl group, the alkenyl group, or the aryl group optionally contains an ether bond, a ketone bond, or an ester bond; R₃ represents a group selected from the group consisting of a hydrogen atom, an alkyl group having 1 to 10 carbon atoms, an alkenyl group having 2 to 10 carbon atoms, an aryl group having 6 to 40 carbon atoms, and combinations thereof, wherein the alkyl group, the alkenyl group, or the aryl group optionally contains an ether bond, a ketone bond, or an ester bond; R₄ represents an aryl group having 6 to 40 carbon atoms optionally substituted with a halogen group, a nitro group, an amino group or a hydroxy group, or heterocyclic group optionally substituted with a halogen group, a nitro group, an amino group or a hydroxy group; R₅ represents a hydrogen atom, or an alkyl group having 1 to 10 carbon atoms optionally substituted with a halogen group, a nitro group, an amino group or a hydroxy group, aryl group having 6 to 40 carbon atoms optionally substituted with a halogen group, a nitro group, an amino group or a hydroxy group, or heterocyclic group optionally substituted with a halogen group, a nitro group, an amino group or a hydroxy group; R₄ and R₅ together with the carbon atom to which they are bonded may form a ring; and n1 and n2 are each an integer of 1 to 3. Note that the definitions of symbols in the formula apply only in this formula.)

As the (A) material for forming an organic film to be used in the present invention, novolac resins obtained by allowing one of or two or more of phenols such as phenol, cresol, xylenol, catechol, resorcinol, hydroquinone, pyrogallol, hydroxyquinol, and phloroglucinol to react with one of or two or more of aldehyde sources such as formaldehyde, paraformaldehyde, and trioxane using an acidic catalyst, and resins and the like including the repeating unit structure represented by the following formula (21) as described in WO 2012/176767 A1 can be further exemplified. 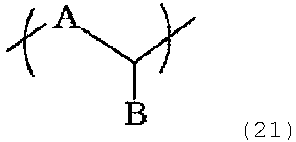 (In the formula (21), A represents a hydroxy group-substituted phenylene group derived from polyhydroxybenzene, and B represents a monovalent fused aromatic hydrocarbon ring group in which two to six benzene rings are fused. Note that the definitions of symbols in the formula apply only in this formula.)

As the (A) material for forming an organic film to be used in the present invention, novolac resins and the like having a fluorene or tetrahydrospirobiindene structure and including the repeating unit structure represented by the following formula (22-1) or (22-2), as described in JP 2005-128509 A, JP 2006-259249 A, JP 2006-259482 A, JP 2006-293298 A, and JP 2007-316282 A can be further exemplified. 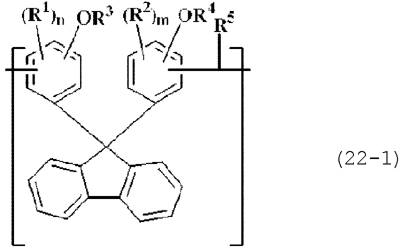 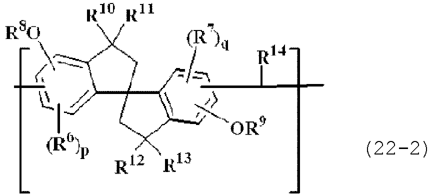 (In the formula (22-1) and the formula (22-2), R¹, R², R⁶, and R⁷ are each independently a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ are each independently a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ are each independently a hydrogen atom, a linear, branched, or cyclic alkyl group having 1 to 10 carbon atoms, or an aryl group having 6 to 10 carbon atoms. n, m, p, and q are integers of 1 to 3. R¹⁰ to R¹³ are each independently a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the definitions of symbols in the formula apply only in this formula.)

As the (A) material for forming an organic film to be used in the present invention, reaction products obtained by the method as described in JP 2012-145897 A can be further exemplified. More specifically, polymers obtained by condensing one or more compounds represented by the following general formulae (23-1) and/or (23-2) with one or more compounds represented by the following general formulae (24-1) and/or (24-2) and/or equivalents thereof can be exemplified. 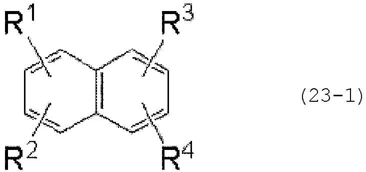 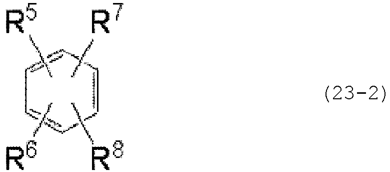 (In the general formula (23-1) and the general formula (23-2), R¹ to R⁸ are each independently a hydrogen atom, a halogen atom, a hydroxy group, an isocyanato group, a glycidyloxy group, a carboxyl group, an amino group, an alkoxy group having 1 to 30 carbon atoms, an alkoxycarbonyl group having 1 to 30 carbon atoms, an alkanoyloxy group having 1 to 30 carbon atoms, or an optionally substituted, saturated or unsaturated organic group having 1 to 30 carbon atoms. Furthermore, two substituents each arbitrarily selected from to R⁴ or R⁵ to R⁸ may be bonded in the molecule to further form a cyclic substituent. Note that the definitions of symbols in the formula apply only in this formula.) 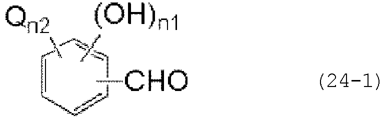 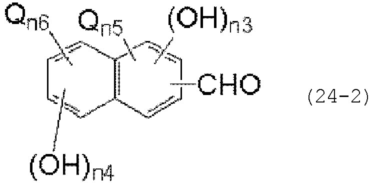 (In the general formula (24-1) and the general formula (24-2), Q is an optionally substituted organic group having 1 to 30 carbon atoms, and furthermore, two Q arbitrarily selected in the molecule may be bonded to form a cyclic substituent. n1 to n6 are the number of each substituent; n1 to n6 are 0, 1 or 2; and in the formula (24-1), hydroxybenzaldehyde is excluded. Also, in the formula (24-2), the relationships of 0 ≤ n3 + n5 ≤ 3, 0 ≤ n4 + n6 ≤ 4, and 1 ≤ n3 + n4 ≤ 4 are satisfied. Note that the definitions of symbols in the formula apply only in this formula.)

Also, polymers can be exemplified that are obtained by condensing one or more compounds represented by the general formulae (23-1) and/or (23-2), one or more compounds represented by the general formulae (24-1) and/or (24-2) and/or equivalents thereof, and one or more compounds represented by the following general formula (25) and/or equivalents thereof.

Y-CHO (25)

(In the formula (25), Y is a hydrogen atom or a monovalent organic group having 30 or less carbon atoms and optionally having a substituent, and the formula (25) is different from the general formula (24-1) and the general formula (24-2). Note that the definitions of symbols in the formula apply only in this formula.)

As the (A) material for forming an organic film to be used in the present invention, compounds and the like including the following structure as described in JP 2017-119671 A can be further exemplified. 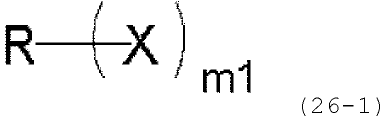 (In the formula (26-1), R is a single bond or an organic group having 1 to 50 carbon atoms; X is a group represented by the following general formula (26-2); and m1 is an integer satisfying 2 ≤ m1 ≤ 10. Note that the definitions of symbols in the formula apply only in this formula.) 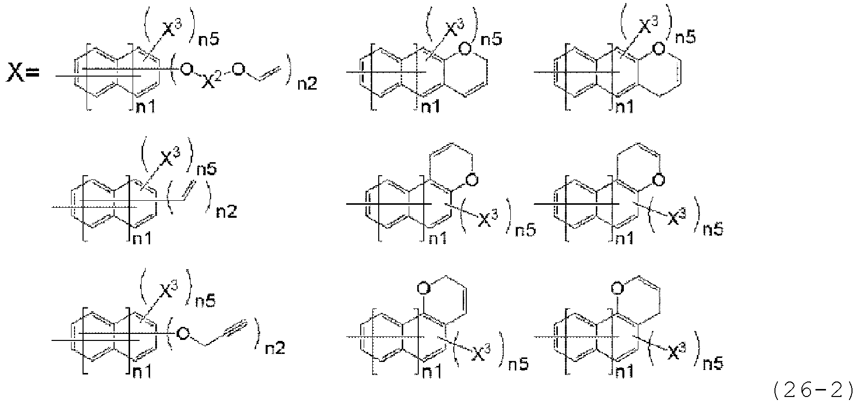 (In the formulae, X² is a divalent organic group having 1 to 10 carbon atoms; n1 is 0 or 1; n2 is 1 or 2; X³ is a group represented by the following general formula (26-3); and n5 is 0, 1 or 2. Note that the definitions of symbols in the formula apply only in this formula.) 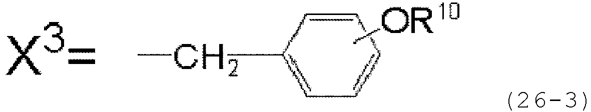 (In the formula, R¹⁰ is a hydrogen atom or a saturated or unsaturated hydrocarbon group having 1 to 10 carbon atoms, and a hydrogen atom on the benzene ring in the formula is optionally substituted with a methyl group or a methoxy group. Note that the definitions of symbols in the formula apply only in this formula.)

As the compound including the above structure, for example, the following compounds are exemplified.

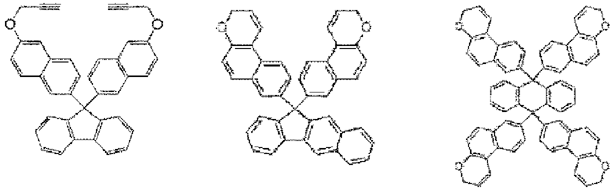

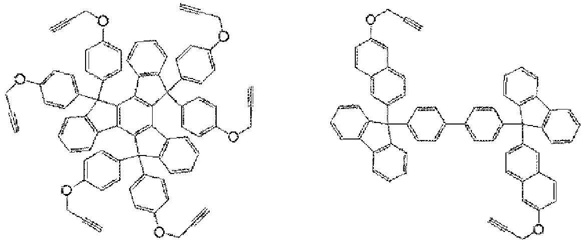

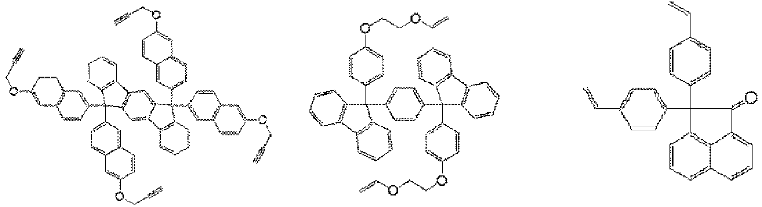

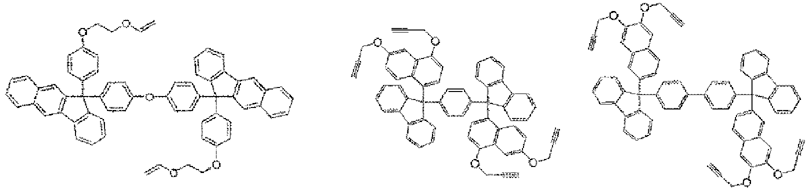

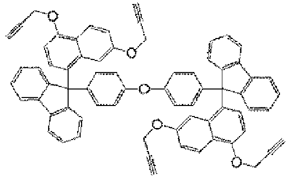

As the (A) material for forming an organic film to be used in the present invention, polymers and the like having a repeating unit represented by the following general formula (27-1) as described in JP 2019-044022 A can be further exemplified. 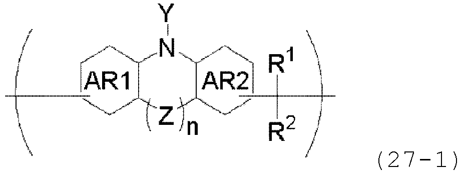 (In the formula (27-1), AR1 and AR2 are benzene rings or naphthalene rings optionally having a substituent; R₁ and R² are each independently a hydrogen atom or an organic group having 1 to 30 carbon atoms; and in the case where R₁ and R² are organic groups, R₁ and R² may be bonded in the molecule to form a cyclic organic group. n is 0 or 1, and when n = 0, AR1 and AR2 do not form a bridged structure between the aromatic rings of AR1 and AR2 via Z, while when n = 1, AR1 and AR2 form a bridged structure between the aromatic rings of AR1 and AR2 via Z. Z is either a single bond or the following formula (27-2). Y is a group represented by the following formula (27-3). Note that the definitions of symbols in the formula apply only in this formula.)

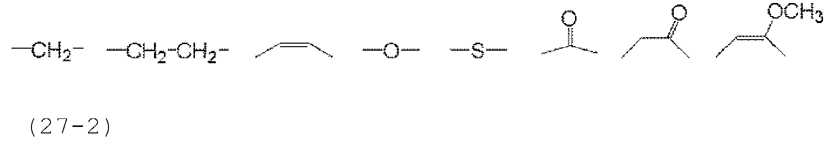

**----R³-C≡C-R⁴** (27-3)

(In the formula (27-3), R³ is a single bond or a divalent organic group having 1 to 20 carbon atoms; R⁴ is a hydrogen atom or a monovalent organic group having 1 to 20 carbon atoms; and the broken line represents a point of attachment. Note that the definitions of symbols in the formula apply only in this formula.)

As the polymer having the repeating unit represented by the general formula (27-1), for example, the following polymers are exemplified.

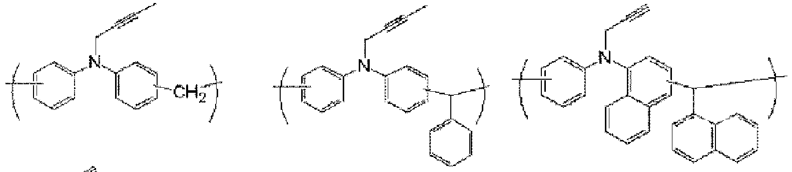

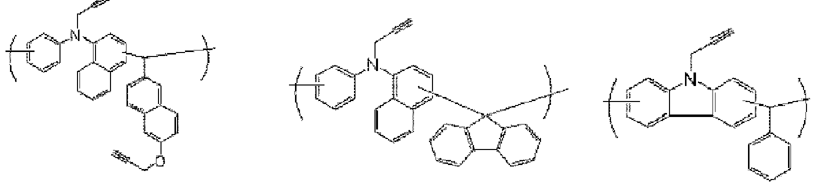

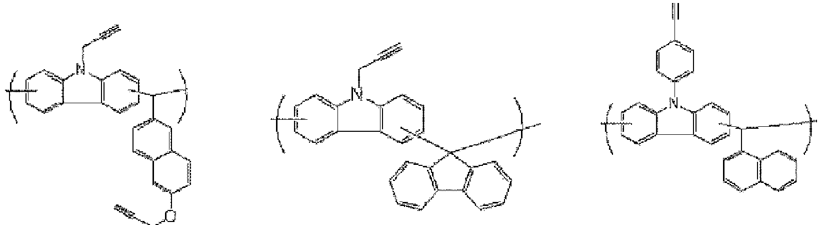

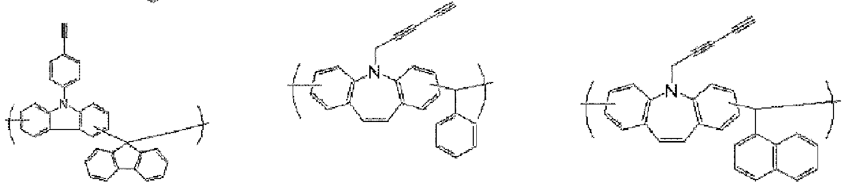

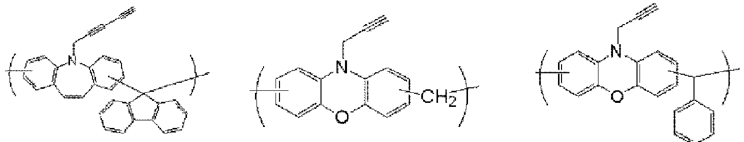

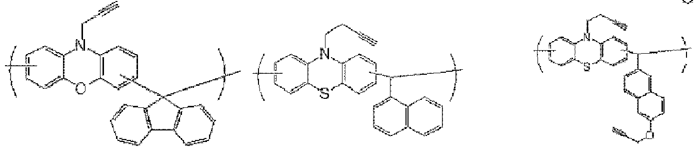

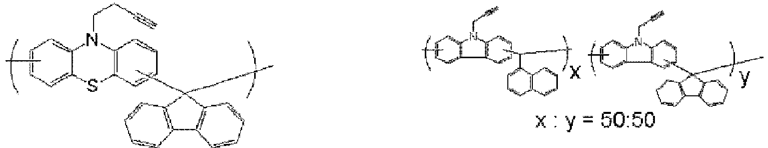

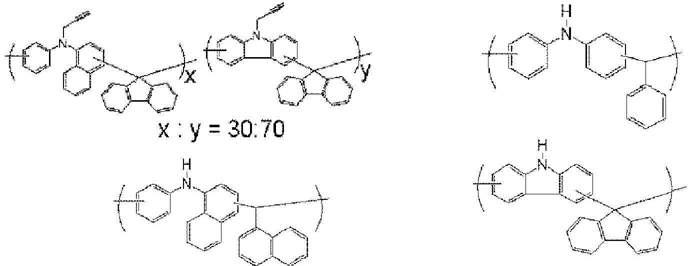

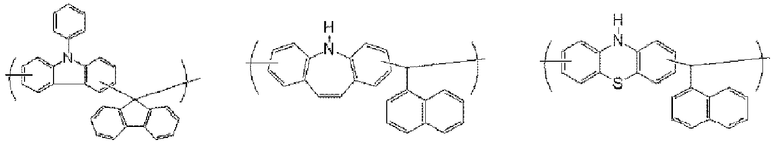

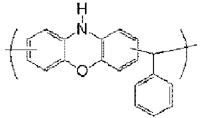

The (A) material for forming an organic film may be synthesized by known methods, or commercially available products may be used.

The amount of the (A) material for forming an organic film blended is not particularly limited as long as the film formability for spin coating of the composition for forming an organic film is satisfied, but the content of the (A) material for forming an organic film is preferably 10 to 40 parts by mass, more preferably 10 to 30 parts by mass, and still more preferably 10 to 25 parts by mass based on 100 parts by mass of the composition for forming an organic film. For example, in the case where holes and trenches with a very high aspect ratio in 3D NAND memory architecture are to be filled with the composition for forming an organic film, it is necessary to increase the amount of the material for forming an organic film blended, but meanwhile, the viscosity of such a composition for forming an organic film is high, resulting in degradation of in-plane uniformity and filling property after spin coating. Even with the above blending ratio of the above (A) material for forming an organic film, the composition for forming an organic film of the present invention can form an organic film that is excellent in in-plane uniformity and filling property, and thus can be suitably applied.

Also, it is preferable that the content of the (B) polymer is 0.01 parts by mass to 5 parts by mass based on 100 parts by mass of the (A) material for forming an organic film. When the composition for forming an organic film comprises the polymer in such a content, the in-plane uniformity of the organic film formed is more excellent.

### [(C) Solvent]

The (C) solvent that can be used in the composition for forming an organic film of the present invention is not particularly restricted as long as it can dissolve the (A) material for forming an organic film and the (B) polymer, and it is preferable if the solvent can also dissolve the acid generator, crosslinking agent, further surfactant, etc., which will be described later. Specifically, solvents with a boiling point of lower than 180°C, such as the solvents described in paragraphs (0091) to (0092) in JP 2007-199653 A, can be used. Above all, it is preferable to use propylene glycol monomethyl ether acetate, propylene glycol monomethyl ether, 2-heptanone, cyclopentanone, cyclohexanone, and a mixture of two or more thereof.

The content of the (C) solvent is 200 to 10,000 parts by mass, more preferably 300 to 5,000 parts by mass, based on 100 parts by mass of the (A) material for forming an organic film. With such a range, the concentration can be adjusted depending on the desired film thickness.

Furthermore, in the composition for forming an organic film of the present invention, it is also possible to add, as the organic solvent that is the (C) solvent, a high boiling point solvent with a boiling point of 180°C or higher to the above solvent with a boiling point of lower than 180°C (a mixture of the solvent with a boiling point of lower than 180°C and a solvent with a boiling point of 180°C or higher). The high boiling point organic solvent is not particularly restricted to be a hydrocarbon, an alcohol, a ketone, an ester, an ether, a chlorinated solvent, etc., as long as it can dissolve the (A) material for forming an organic film and the (B) polymer, but as specific examples thereof, the following can be exemplified: 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butylmethyl ether, triethylene glycol dimethyl ether, triethylene glycol monomethyl ether, triethylene glycol-n-butyl ether, triethylene glycol butylmethyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, dihexyl malonate, diethyl succinate, dipropyl succinate, dibutyl succinate, dihexyl succinate, dimethyl adipate, diethyl adipate, dibutyl adipate, etc. One of these may be used alone, or a mixture thereof may be used.

The boiling point of the above high boiling point solvent may be selected as appropriate depending on the temperature at which the (A) material for forming an organic film is subjected to a heat treatment. The boiling point of the high boiling point solvent to be added is preferably 180°C to 300°C, and still more preferably 200°C to 300°C. Such a boiling point prevents the evaporation rate at baking (heat treatment) from becoming excessive, which would otherwise occur if the boiling point is too low. Thus, sufficient thermal flowability can be obtained. Also, with such a boiling point, the high boiling point solvent evaporates after baking and does not remain in the film, and thus, the film properties such as etching resistance are not adversely affected.

Also, in the case where the above high boiling point solvent is used, it is preferable to set the amount of the high boiling point solvent blended to 1 to 30 parts by mass based on 100 parts by mass of the solvent with a boiling point of lower than 180°C. With such an amount blended, there is no risk that the high boiling point solvent remains in the film, leading to degradation of film properties such as etching resistance, while sufficient thermal flowability can be imparted during baking with an appropriate amount blended.

With such a composition for forming an organic film, a composition for forming an organic film that combines a high degree of filling and excellent planarizing property can be achieved by imparting thermal flowability due to the addition of a high boiling point solvent to the above (A) material for forming an organic film.

### [Other components]

In addition, various other components can be further added to the composition for forming an organic film of the present invention.

### [Acid Generator]

An acid generator may be added to further promote the crosslinking reaction. The acid generator includes a material that generates an acid by thermal decomposition and a material that generates an acid by light irradiation, but any acid generator can be added. Specific examples of the acid generator may include those described in paragraphs [0061] to [0085] in JP 2007-199653 A. One kind of the above acid generator, or a combination of two or more kinds thereof can be used. In the case where an acid generator is added, the amount thereof added is preferably 0.05 to 50 parts by mass, and more preferably 0.1 to 10 parts by mass based on 100 parts by mass of the (A) material for forming an organic film. With such an amount, the crosslinking reaction can be promoted and a dense film can be formed.

### [Crosslinking Agent]

A crosslinking agent may be added to further promote the crosslinking reaction. Specific examples of the crosslinking agent may include those described in paragraphs [0055] to [0060] in JP 2007-199653 A. One kind of the crosslinking agent, or a combination of two or more kinds thereof can be used. The amount of the crosslinking agent added is preferably 1 to 100 parts by mass, and more preferably 5 to 50 parts by mass based on 100 parts by mass of the (A) material for forming an organic film. With such an amount, curability can be enhanced and intermixing with an upper layer film can be further suppressed.

### [Surfactant]

In addition, a further surfactant other than the (B) polymer of the present invention can also be added to the composition for forming an organic film of the present invention in order to further improve the in-plane uniformity in spin coating. Specific examples of the further surfactant may include those described in paragraphs [0142] to [0147] in JP 2009-269953 A. One kind of the above further surfactant, or a combination of two or more kinds thereof can be used. In the case where a further surfactant is added, the amount thereof added is preferably 0.01 to 10 parts by mass, and more preferably 0.05 to 5 parts by mass based on 100 parts by mass of the material for forming an organic film. With such an amount, an organic film that is excellent in in-plane uniformity can be formed.

### [Basic Compound]

Furthermore, a basic compound for improving storage stability can be added to the composition for forming an organic film of the present invention. The basic compound acts as a quencher for the acid, preventing the acid generated in a minute amount by the acid generator from causing the crosslinking reaction to progress. Specific examples of such a basic compound may include those described in paragraphs [0086] to [0090] in JP 2007-199653 A. One kind of the above basic compound, or a combination of two or more kinds thereof can be used. In the case where an acid generator is added, the amount thereof added is preferably 0.05 to 50 parts by mass, and more preferably 0.1 to 10 parts by mass based on 100 parts by mass of the (A) material for forming an organic film. With such an amount, it becomes possible to improve the storage stability of the composition for forming an organic film.

As described above, the composition for forming an organic film of the present invention can be a composition for forming an organic film that is excellent in hump suppressing property during the EBR process. Accordingly, the composition for forming an organic film of the present invention is quite useful as a resist underlayer film material (organic film material) for multilayer resist processes such as a two-layer resist process, a three-layer resist process using a silicon-containing resist middle layer film or silicon-containing inorganic hard mask middle layer film, and a four-layer resist process using a silicon-containing resist middle layer film or silicon-containing inorganic hard mask middle layer film, and an organic antireflective film or adhesion film.

### [Method for Forming Organic Film]

In the present invention, an organic film can be formed by spin-coating the composition for forming an organic film of the present invention on a substrate to be processed to obtain a coating film, and forming a cured film by a heat treatment at appropriate temperature and time ranges.

The present invention provides a method for forming an organic film to be used in a manufacturing process of a semiconductor device, the method comprising spin-coating the composition for forming an organic film described above on a substrate to be processed to obtain a coating film, and forming a cured film by a heat treatment to form an organic film.

The heat treatment for the coating film is preferably carried out under conditions at a temperature of 100°C or higher and 600°C or lower for a range of 10 to 600 seconds.

In this method for forming an organic film, the composition for forming an organic film of the present invention mentioned above is first spin-coated on a substrate to be processed. By using the spin coating method, favorable filling property can be obtained. After removing the film at the edge in the EBR process, baking (heat treatment) is carried out in order to promote the crosslinking reaction. Note that since this baking can evaporate the solvent in the composition, mixing can be prevented even in the case where a resist upper layer film or a silicon-containing resist middle layer film is formed on the organic film.

The baking is carried out preferably at a temperature of 100°C or higher and 600°C or lower for a range of 10 to 600 seconds, and more preferably at a temperature of 200°C or higher and 500°C or lower for a range of 10 to 300 seconds. In considering the influences of device damage and wafer deformation, the upper limit of the heating temperature in lithographic wafer process is preferably 600°C or lower, and more preferably 500°C or lower. By performing the heat treatment under such conditions, the crosslinking reaction can be promoted and an organic film can be formed without mixing with the film formed on the upper layer.

### [Patterning Process]

Hereinafter, a patterning process using the composition for forming an organic film of the present invention will be described. The patterning process of the present invention uses the composition for forming an organic film of the present invention described above to form an organic film by the method for forming an organic film of the present invention described above to form a pattern.

### [Three-Layer Resist Process Using Silicon-Containing Resist Middle Layer Film]

The present invention provides a patterning process comprising: forming an organic film on a body to be processed using the composition for forming an organic film of the present invention described above; forming a silicon-containing resist middle layer film on the organic film using a silicon-containing resist middle layer film material; forming a resist upper layer film on the silicon-containing resist middle layer film using a resist upper layer film material composed of a photoresist composition; forming a circuit pattern in the resist upper layer film; transferring the pattern to the silicon-containing resist middle layer film by etching using as a mask the resist upper layer film in which the circuit pattern has been formed; transferring the pattern to the organic film by etching using as a mask the silicon-containing resist middle layer film to which the pattern has been transferred; and further forming the pattern in the body to be processed by etching using as a mask the organic film to which the pattern has been transferred.

It is preferable to use as the body to be processed, a semiconductor device substrate, or the semiconductor device substrate on which any of a metal film, a metal carbide film, a metal oxide film, a metal nitride film, a metal oxycarbide film, and a metal oxynitride film has been formed, and more specifically, although not particularly limited, a substrate such as Si, α-Si, p-Si, SiO₂, SiN, SiON, W, TiN, or Al, or the substrate on which the above metal film or the like is formed as the layer to be processed, is used.

As the layer to be processed, various Low-k films made of Si, SiO₂, SiON, SiN, p-Si, α-Si, W, W-Si, Al, Cu, Al-Si, or the like and stopper films thereof are used, for example, and the layer can be formed to have a thickness of normally 50 to 10,000 nm, particularly 100 to 5,000 nm. Note that in the case where the layer to be processed is formed, the substrate and the layer to be processed are formed from different materials.

Note that it is preferable to use one in which a metal constituting the body to be processed includes silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When forming an organic film on the body to be processed using the composition for forming an organic film of the present invention, although not limited, for example, the method for forming an organic film of the present invention mentioned above may be applied.

Next, a resist middle layer film (silicon-containing resist middle layer film) is formed on the organic film using a silicon atom-containing resist middle layer film material. As the silicon atom-containing resist middle layer film material, a polysiloxane-based middle layer film material is preferable. By making the silicon-containing resist middle layer film to have an antireflective effect, reflection can be suppressed. Particularly, for 193 nm light exposure, a material containing many aromatic groups and having high etching selectivity relative to the substrate is used as a composition for forming an organic film, so that the k-value and thus the substrate reflection are increased; in contrast, the reflection can be suppressed by imparting absorption to the silicon-containing resist middle layer film so as to have an appropriate k-value, and the substrate reflection can be reduced to 0.5% or less. As the silicon-containing resist middle layer film having an antireflective effect, a polysiloxane is preferably used that has an anthryl group for 248 nm or 157 nm light exposure, or a phenyl group or a light-absorbing group having a silicon-silicon bond for 193 nm light exposure in a pendant structure, and that is crosslinked by an acid or heat.

Next, a resist upper layer film is formed on the silicon-containing resist middle layer film using a resist upper layer film material composed of a photoresist composition. The resist upper layer film material may be a positive type or a negative type, and any generally-used photoresist composition can be employed. After spin coating of the resist upper layer film material, it is preferable to carry out pre-baking at 60 to 180°C for a range of 10 to 300 seconds. Thereafter, light exposure, post-exposure bake (PEB), and development are performed according to conventional methods to obtain a resist upper layer film pattern. Note that the thickness of the resist upper layer film is not particularly restricted, but is preferably 30 to 500 nm, and particularly preferably 50 to 400 nm.

Next, a circuit pattern (resist upper layer film pattern) is formed in the resist upper layer film. It is preferable that, in formation of the circuit pattern, the circuit pattern is formed by lithography using light with a wavelength of 10 nm or more and 300 nm or less, direct drawing with electron beams, nanoimprinting, or a combination thereof.

Examples of the exposure light may include high energy beams with a wavelength of 300 nm or less, specifically far ultraviolet ray, KrF excimer laser light (248 nm), ArF excimer laser light (193 nm), F2 laser light (157 nm), Kr2 laser light (146 nm), Ar2 laser light (126 nm), soft X-ray (EUV) of 3 to 20 nm, electron beams (EB), ion beams, and X-ray.

Also, it is preferable that, in formation of the circuit pattern, the circuit pattern is developed by alkali development or an organic solvent.

Next, the pattern is transferred to the silicon-containing resist middle layer film by etching using as a mask the resist upper layer film in which the circuit pattern has been formed. It is preferable to carry out the etching of the silicon-containing resist middle layer film, which is carried out using the resist upper layer film pattern as a mask, by using a fluorocarbon-based gas. As a result, the pattern is transferred to the silicon-containing resist middle layer film (silicon-containing resist middle layer film pattern).

Next, the pattern is transferred to the organic film by etching using as a mask the silicon-containing resist middle layer film to which the pattern has been transferred (silicon-containing resist middle layer film pattern). Since the silicon-containing resist middle layer film exhibits etching resistance to an oxygen gas or a hydrogen gas, it is preferable to carry out the etching of the organic film, which is carried out using the silicon-containing resist middle layer film pattern as a mask, by using an etching gas mainly composed of an oxygen gas or a hydrogen gas. As a result, the pattern is transferred to the organic film (organic film pattern).

Next, the pattern is formed in the body to be processed by etching using as a mask the organic film to which the pattern has been transferred (organic film pattern).

The next etching of the body to be processed (layer to be processed) can be carried out by conventional methods. For example, if the body to be processed is SiO₂, SiN, or a silica-based low dielectric insulating film, etching is carried out mainly with a fluorocarbon-based gas, and if it is p-Si, Al, or W, etching is carried out mainly with a chlorine-based or bromine-based gas. In the case where the substrate processing is carried out by etching with a fluorocarbon-based gas, the silicon-containing resist middle layer film pattern is removed at the same time as the processing of the body to be processed. On the other hand, in the case where the processing of the body to be processed is carried out by etching with a chlorine-based or bromine-based gas, in order to remove the silicon-containing resist middle layer film pattern, dry etching removal with a fluorocarbon-based gas needs to be separately carried out after the processing of the body to be processed.

The organic film obtained by using the composition for forming an organic film of the present invention can have excellent etching resistance during etching of the body to be processed as described above.

### [Four-Layer Resist Process Using Silicon-Containing Resist Middle Layer Film and Organic Antireflective Film or Adhesion Film]

The present invention also provides a patterning process comprising: forming an organic film on a body to be processed using the composition for forming an organic film of the present invention described above; forming a silicon-containing resist middle layer film on the organic film using a silicon-containing resist middle layer film material; forming an organic antireflective film or an adhesion film on the silicon-containing resist middle layer film; forming a resist upper layer film on the organic antireflective film or adhesion film using a resist upper layer film material composed of a photoresist composition; forming a circuit pattern in the resist upper layer film; transferring the pattern to the organic antireflective film or adhesion film and the silicon-containing resist middle layer film by etching using as a mask the resist upper layer film in which the circuit pattern has been formed; transferring the pattern to the organic film by etching using as a mask the silicon-containing resist middle layer film to which the pattern has been transferred; and further forming the pattern in the body to be processed by etching using as a mask the organic film to which the pattern has been transferred.

Note that this method can be carried out in the same manner as the three-layer resist process using the silicon-containing resist middle layer film described above, except that an organic antireflective film (BARC) or adhesion film is formed between the silicon-containing resist middle layer film and the resist upper layer film.

The organic antireflective film and the adhesion film can be formed by spin coating using a known organic antireflective film material.

### [Three-Layer Resist Process Using Inorganic Hard Mask Middle Layer Film]

The present invention also provides a patterning process comprising: forming an organic film on a body to be processed using the composition for forming an organic film of the present invention described above; forming an inorganic hard mask selected from the group consisting of a silicon oxide film, a silicon nitride film, and a silicon oxynitride film on the organic film; forming a resist upper layer film on the inorganic hard mask using a resist upper layer film material composed of a photoresist composition; forming a circuit pattern in the resist upper layer film; transferring the pattern to the inorganic hard mask by etching using as a mask the resist upper layer film in which the circuit pattern has been formed; transferring the pattern to the organic film by etching using as a mask the inorganic hard mask to which the pattern has been transferred; and further forming the pattern in the body to be processed by etching using as a mask the organic film to which the pattern has been transferred.

Note that this method can be carried out in the same manner as the three-layer resist process using the silicon-containing resist middle layer film described above, except that an inorganic hard mask middle layer film is formed instead of the silicon-containing resist middle layer film on the organic film.

The inorganic hard mask middle layer film selected from the group consisting of a silicon oxide film, a silicon nitride film, and a silicon oxynitride film (SiON film) can be formed by, for example, a CVD method, an ALD method, or the like. The method for forming a silicon nitride film is described in, for example, JP 2002-334869 A, WO 2004/066377 A1, and the like. The film thickness of the inorganic hard mask middle layer film is preferably 5 to 200 nm, and more preferably 10 to 100 nm. As the inorganic hard mask middle layer film, a SiON film is most preferably used that is highly effective as an antireflective film.

### [Four-Layer Resist Process Using Inorganic Hard Mask Middle Layer Film and Organic Antireflective Film or Adhesion Film]

The present invention also provides a patterning process comprising: forming an organic film on a body to be processed using the composition for forming an organic film of the present invention described above; forming an inorganic hard mask selected from the group consisting of a silicon oxide film, a silicon nitride film, and a silicon oxynitride film on the organic film; forming an organic antireflective film or an adhesion film on the inorganic hard mask; forming a resist upper layer film on the organic antireflective film or adhesion film using a resist upper layer film material composed of a photoresist composition; forming a circuit pattern in the resist upper layer film; transferring the pattern to the organic antireflective film or adhesion film and the inorganic hard mask by etching using as a mask the resist upper layer film in which the circuit pattern has been formed; transferring the pattern to the organic film by etching using as a mask the inorganic hard mask to which the pattern has been transferred; and further forming the pattern in the body to be processed by etching using as a mask the organic film to which the pattern has been transferred.

Note that this method can be carried out in the same manner as the three-layer resist process using the inorganic hard mask middle layer film described above, except that an organic antireflective film (BARC) or adhesion film is formed between the inorganic hard mask middle layer film and the resist upper layer film.

Particularly, in the case where a SiON film is used as the inorganic hard mask middle layer film, two antireflective films including the SiON film and the BARC make it possible to suppress the reflection even in liquid immersion exposure at a high NA of more than 1.0. Another merit of the BARC formation is having an effect of reducing trailing of the resist upper layer film pattern immediately above the SiON film.

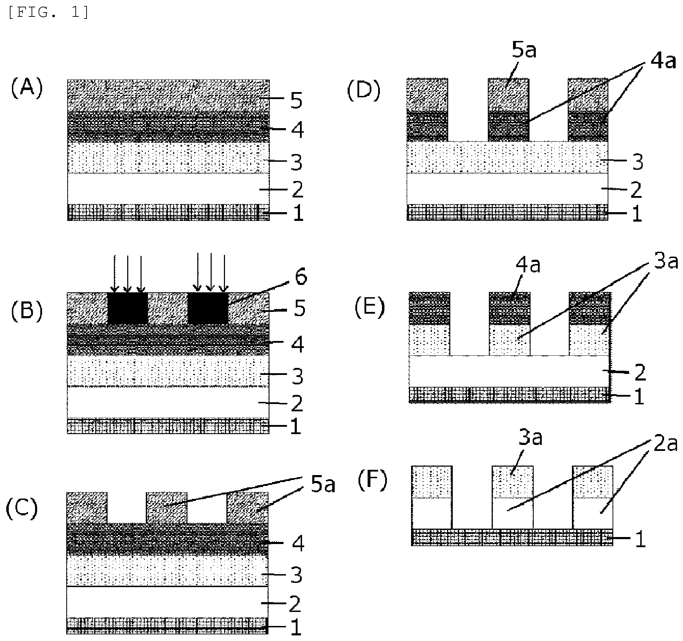

Here, an example of the patterning process using the three-layer resist process of the present invention is shown in FIG. 1(A) to (F). As shown in FIG. 1(A), in the case of three-layer resist process, an organic film 3 is formed by using the composition for forming an organic film of the present invention on a layer to be processed (body to be processed) 2, which has been formed on a substrate 1. Then, a silicon-containing resist middle layer film 4 is formed on the organic film 3, and a resist upper layer film 5 is formed thereon. Next, as shown in FIG. 1(B), a portion to be exposed 6 of the resist upper layer film 5 is exposed to light, followed by PEB (post-exposure bake). Next, as shown in FIG. 1(C), a resist upper layer film pattern 5a is formed by carrying out development. Next, as shown in FIG. 1(D), the silicon-containing resist middle layer film 4 is dry-etched using a fluorocarbon-based gas, using the resist upper layer film pattern 5a as a mask, thereby forming a silicon-containing resist middle layer film pattern 4a. Next, the resist upper layer film pattern 5a is removed, and then, as shown in FIG. 1(E), the organic film 3 is etched with oxygen plasma using the silicon-containing resist middle layer film pattern 4a as a mask, thereby forming an organic film pattern 3a. Furthermore, as shown in FIG. 1(F), the silicon-containing resist middle layer film pattern 4a is removed, and then the layer to be processed 2 is etched using the organic film pattern 3a as a mask, thereby forming a pattern 2a.

In this example of patterning process, humps are suppressed at the time of formation of the organic film 3, which makes it possible to reduce defects generated from humps in the organic film during the dry etching of FIG. 1(D), (E), and (F).

In the case where an inorganic hard mask middle layer film is formed, the silicon-containing resist middle layer film 4 may be changed to an inorganic hard mask middle layer film, and in the case where a BARC or adhesion film is formed, a BARC or adhesion film may be formed between the silicon-containing resist middle layer film 4 and the resist upper layer film 5. The etching of the BARC or adhesion film may be carried out continuously prior to the etching of the silicon-containing resist middle layer film 4, or the etching of the BARC or adhesion film only may be carried out first, and then the etching of the silicon-containing resist middle layer film 4 may be carried out with a different etching apparatus or by other means.

As described above, according to the patterning processes of the present invention, it is possible to form a fine pattern in the body to be processed by the multilayer resist processes with high precision, and also to suppress hump formation in the organic film, thereby reducing defects derived from humps in the organic film.

### EXAMPLE

Hereinafter, the present invention will be further specifically described by referring to Synthesis Examples, Comparative Synthesis Examples, Examples, and Comparative Examples. However, the present invention is not limited thereto. Note that the measurement method of molecular weight was specifically carried out by the following method. The weight average molecular weight (Mw) and number average molecular weight (Mn) were determined in terms of polystyrene by gel permeation chromatography (GPC) using tetrahydrofuran as the eluent (solvent) under the condition where the temperature was 40°C, and the dispersity (Mw/Mn) was determined.

### [Synthesis of Polymers (B-1) to (B-10)]

For the synthesis of compounds (B-1) to (B-10) used in the preparation of the compositions for forming an organic film (UDL-1 to 65) of Examples, the following branched long chain alkyl-containing compounds (a1) to (a4) and oxygen atom-containing (meth)acrylic monomers (b1) to (b5) were used.

### (Branched Long Chain Alkyl-Containing Compounds)

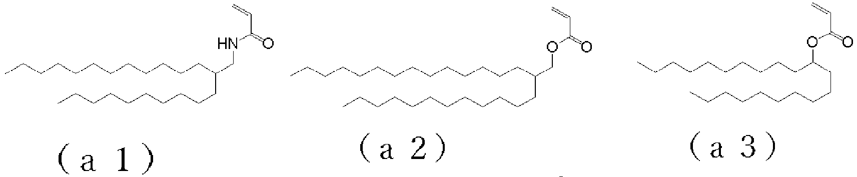

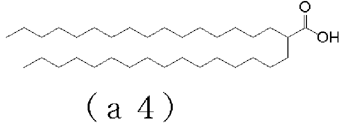

### (Oxygen Atom-Containing (Meth)Acrylic Monomers)

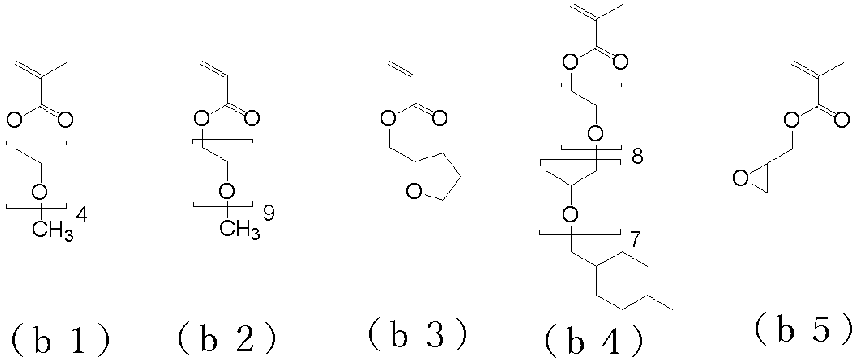

### [Synthesis Example 1] Synthesis of Polymer (B-1)

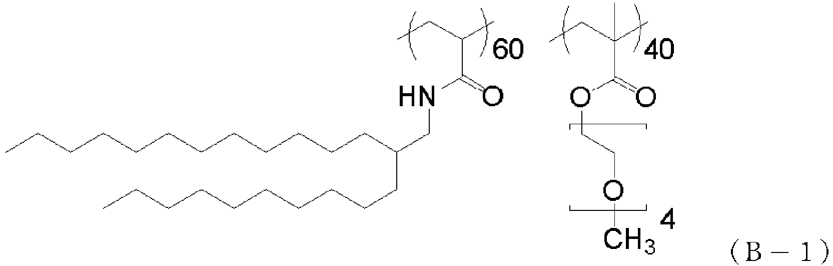

To 4.89 g of the branched long chain alkyl-containing compound (a1) and 2.21 g of the oxygen atom-containing (meth)acrylic monomer (b1) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 47.3 g of a solution of the polymer (B-1) in PGMEA (compound concentration of 15%).

The weight average molecular weight (Mw) and dispersity (Mw/Mn) were determined by GPC, and the results were as follows.
(B-1): Mw = 5370, Mw/Mn = 3.51

### [Synthesis Example 2] Synthesis of Polymer (B-2)

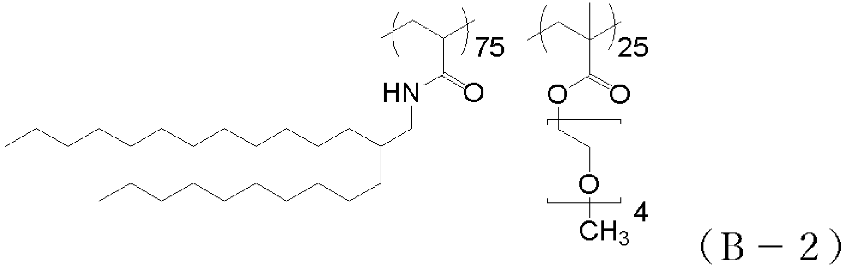

To 6.12 g of the branched long chain alkyl-containing compound (a1) and 1.38 g of the oxygen atom-containing (meth)acrylic monomer (b1) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 50.0 g of a solution of the polymer (B-2) in PGMEA (compound concentration of 15%).

The weight average molecular weight (Mw) and dispersity (Mw/Mn) were determined by GPC, and the results were as follows.
(B-2): Mw = 6150, Mw/Mn = 3.78

### [Synthesis Example 3] Synthesis of Polymer (B-3)

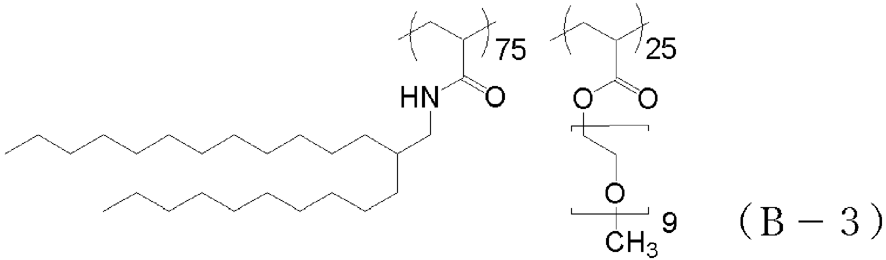

To 6.12 g of the branched long chain alkyl-containing compound (a1) and 2.41 g of the oxygen atom-containing (meth)acrylic monomer (b2) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 56.9 g of a solution of the polymer (B-3) in PGMEA (compound concentration of 15%).

The weight average molecular weight (Mw) and dispersity (Mw/Mn) were determined by GPC, and the results were as follows.
(B-3): Mw = 9140, Mw/Mn = 2.94

### [Synthesis Example 4] Synthesis of Polymer (B-4)

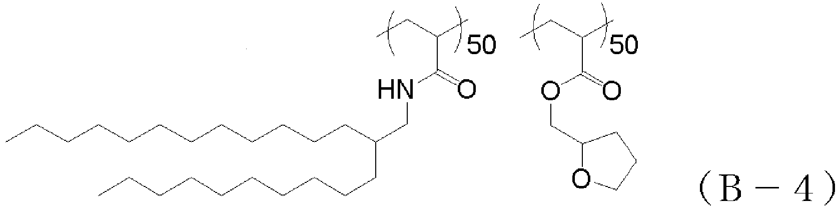

To 4.08 g of the branched long chain alkyl-containing compound (a1) and 1.56 g of the oxygen atom-containing (meth)acrylic monomer (b3) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 37.6 g of a solution of the polymer (B-4) in PGMEA (compound concentration of 15%).

The weight average molecular weight (Mw) and dispersity (Mw/Mn) were determined by GPC, and the results were as follows.
(B-4): Mw = 4950, Mw/Mn = 2.26

### [Synthesis Example 5] Synthesis of Polymer (B-5)

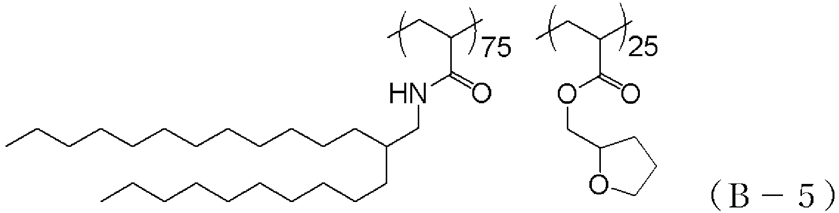

To 6.12 g of the branched long chain alkyl-containing compound (a1) and 0.78 g of the oxygen atom-containing (meth)acrylic monomer (b3) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 46.0 g of a solution of the polymer (B-5) in PGMEA (compound concentration of 15%).

The weight average molecular weight (Mw) and dispersity (Mw/Mn) were determined by GPC, and the results were as follows.
(B-5): Mw = 4130, Mw/Mn = 2.59

### [Synthesis Example 6] Synthesis of Polymer (B-6)

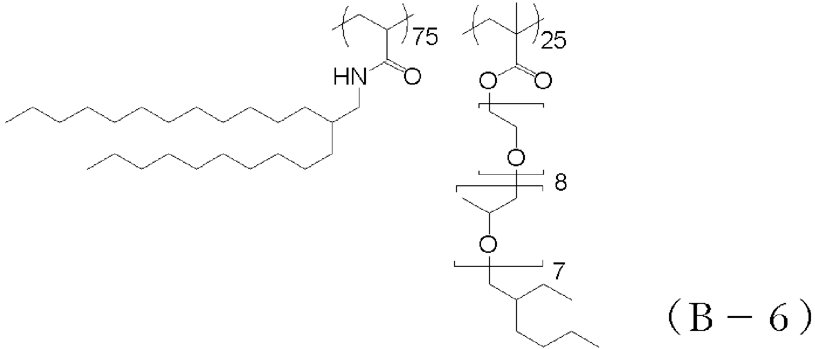

To 6.12 g of the branched long chain alkyl-containing compound (a1) and 4.79 g of the oxygen atom-containing (meth)acrylic monomer (b4) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 72.7 g of a solution of the polymer (B-6) in PGMEA (compound concentration of 15%).

The weight average molecular weight (Mw) and dispersity (Mw/Mn) were determined by GPC, and the results were as follows.
(B-6): Mw = 4710, Mw/Mn = 2.84

### [Synthesis Example 7] Synthesis of Polymer (B-7)

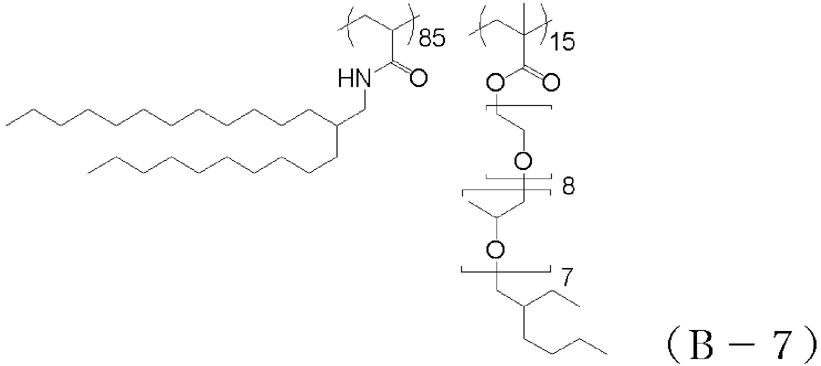

To 6.93 g of the branched long chain alkyl-containing compound (a1) and 2.87 g of the oxygen atom-containing (meth)acrylic monomer (b4) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 65.3 g of a solution of the polymer (B-7) in PGMEA (compound concentration of 15%).

The weight average molecular weight (Mw) and dispersity (Mw/Mn) were determined by GPC, and the results were as follows.
(B-7): Mw = 4840, Mw/Mn = 2.75

### [Synthesis Example 8] Synthesis of Polymer (B-8)

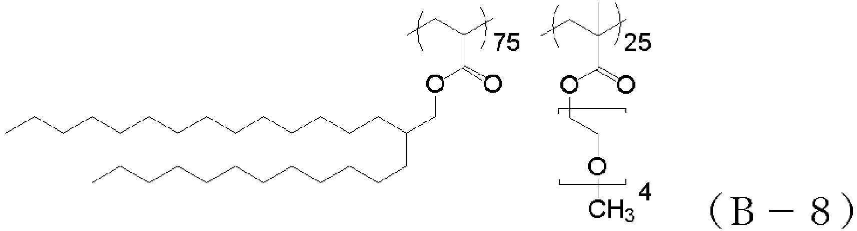

To 6.97 g of the branched long chain alkyl-containing compound (a2) and 1.38 g of the oxygen atom-containing (meth)acrylic monomer (b1) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 55.7 g of a solution of the polymer (B-8) in PGMEA (compound concentration of 15%).

The weight average molecular weight (Mw) and dispersity (Mw/Mn) were determined by GPC, and the results were as follows.
(B-8): Mw = 6300, Mw/Mn = 3.89

### [Synthesis Example 9] Synthesis of Polymer (B-9)

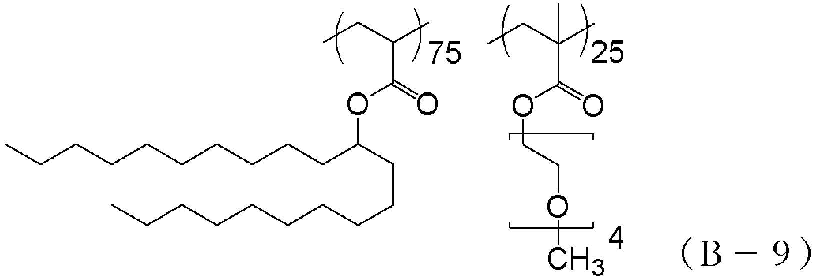

To 5.50 g of the branched long chain alkyl-containing compound (a3) and 1.38 g of the oxygen atom-containing (meth)acrylic monomer (b1) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 45.9 g of a solution of the polymer (B-9) in PGMEA (compound concentration of 15%).

The weight average molecular weight (Mw) and dispersity (Mw/Mn) were determined by GPC, and the results were as follows.
(B-9): Mw = 6050, Mw/Mn = 3.57

### [Synthesis Example 10] Synthesis of Polymer (B-10)

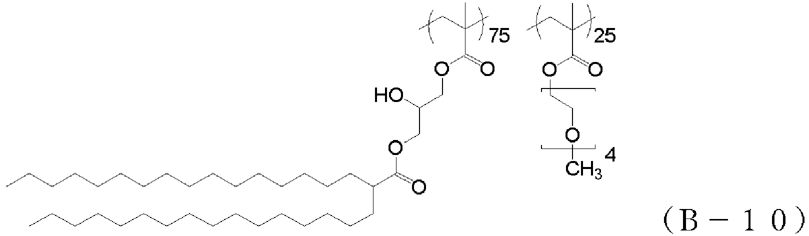

To 2.13 g of the oxygen atom-containing (meth) acrylic monomer (b5) and 1.38 g of the oxygen atom-containing (meth)acrylic monomer (b1) was added 20.0 g of PGME (propylene glycol monomethyl ether), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature.

Subsequently, to the obtained reaction solution were added 7.63 g of the branched long chain alkyl-containing compound (a4) and 0.34 g of benzyltriethylammonium chloride and the temperature was raised to 105°C under a nitrogen atmosphere, and the reaction was carried out at an internal temperature of 105°C for 24 hours. After cooling at room temperature, 100 ml of methyl isobutyl ketone and 100 ml of pure water were added to the reaction solution, which was homogenized, and the separated aqueous layer was then removed. Furthermore, the organic layer was washed twice with 100 ml of a 3% nitric acid aqueous solution and five times with 100 ml of pure water, and the organic layer was then evaporated under reduced pressure to dryness. To the residue, 100 g of PGMEA was added to make a homogeneous solution, which was then evaporated under reduced pressure to dryness and further diluted with PGMEA to obtain 74.3 g of a solution of the polymer (B-10) in PGMEA (compound concentration 15%).

The weight average molecular weight (Mw) and dispersity (Mw/Mn) were determined by GPC, and the results were as follows.
(B-10): Mw = 11090, Mw/Mn = 2.98

### [Synthesis of Comparative Polymers (R-1) to (R-2)]

For the synthesis of comparative polymers (R1) to (R2) used in the preparation of compositions for forming an organic film, the following monomers (r1) to (r3) were used.

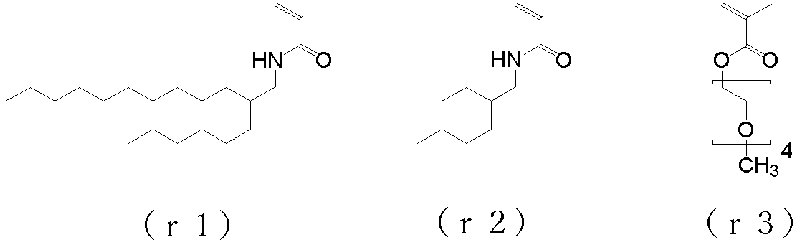

### [Comparative Synthesis Example 1] Synthesis of Comparative Polymer (R-1)

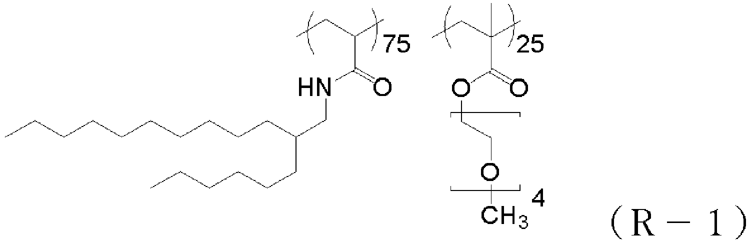

To 5.06 g of the monomer (r1) and 1.38 g of the monomer (r3) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 42.9 g of a solution of the polymer (R-1) in PGMEA (compound concentration of 15%).

The weight average molecular weight (Mw) and dispersity (Mw/Mn) were determined by GPC, and the results were as follows.
(R-1): Mw = 10120, Mw/Mn = 3.95

### [Comparative Synthesis Example 2] Synthesis of Comparative Polymer (R-2)

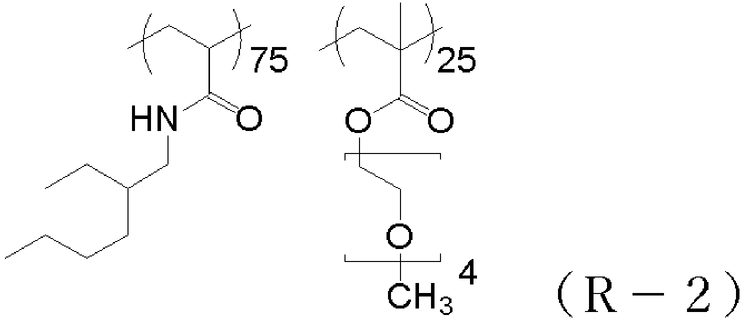

To 2.97 g of the monomer (r2) and 1.38 g of the monomer (r3) was added 20.0 g of PGMEA (propylene glycol monoethyl ether acetate), which was stirred to form a homogeneous solution, followed by nitrogen bubbling for 15 minutes. Thereafter, 0.23 g of dimethyl 2,2-azobis(2-methylpropionate) was added to the homogeneous solution and the temperature was raised to 85°C under a nitrogen atmosphere, and the reaction was carried out at an internal temperature of 85°C for 24 hours. The reaction solution was cooled to room temperature and then diluted with PGMEA to obtain 29.1 g of a solution of the polymer (R-2) in PGMEA (compound concentration of 15%).

The weight average molecular weight (Mw) and dispersity (Mw/Mn) were determined by GPC, and the results were as follows.
(R-2): Mw = 9770, Mw/Mn = 3.65

### [(A) Material for Forming Organic Film (Resin or Compound)]

In the preparation of the compositions for forming an organic film (UDL-1 to 65 and comparative UDL-1 to 13) of Examples and Comparative Examples, the following resins or compounds were used as the (A) material for forming an organic film.
M1: Resin represented by the following formula (M1)
M2: Resin represented by the following formula (M2)
M3: Compound represented by the following formula (M3)
M4: Compound represented by the following formula (M4)
M5: Resin represented by the following formula (M5)
M6: Resin represented by the following formula (M6)

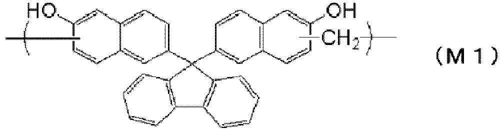

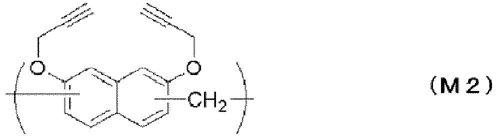

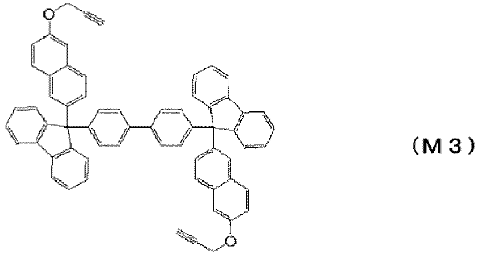

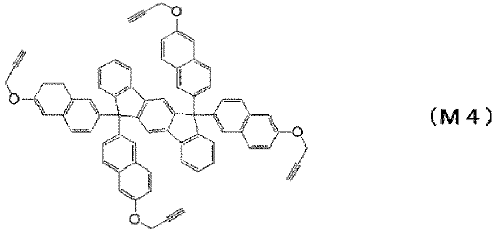

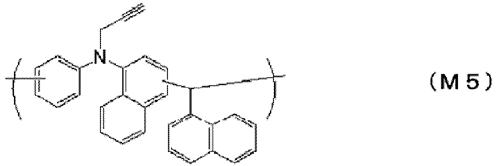

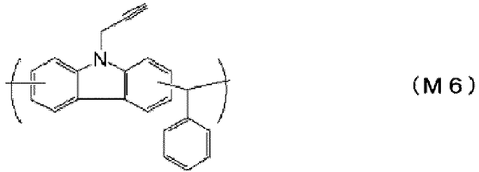

### [(C) Solvent]

In the preparation of the compositions for forming an organic film (UDL-1 to 65 and comparative UDL-1 to 13) of Examples and Comparative Examples, the following solvents were each used as the (C) solvent.
(S1): Propylene glycol monomethyl ether acetate
(S2): Propylene glycol monoethyl ether

### [Preparation of Compositions for Forming Organic Film (UDL-1 to 65 and Comparative UDL-1 to 13)]

Any one of the above compounds (B-1) to (B-10) and (R-1) to (R-2) as the polymer, any one of the above materials for forming an organic film (M1) to (M6) as the resin for forming an organic film, and one or both of the (C) solvents were dissolved in the proportions shown in Table 1 to Table 3. The mixture thus obtained was filtered through a 0.1 µm filter made of fluororesin, thereby preparing each of the compositions for forming an organic film (UDL-1 to 65 and comparative UDL-1 to 7). Also, any one of the above materials for forming an organic film (M1) to (M6) and the above solvent (S1) were dissolved in the proportions shown in Table 3. The mixture thus obtained was filtered through a 0.1 µm filter made of fluororesin, thereby preparing each of the compositions for forming an organic film (comparative UDL-8 to 13). The results are shown in Table 1 to Table 3.

**[Table 1]**

| Composition for forming organic film | Resin for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-1 | (M 1) | 10.00 | (B-1) | 0.10 | (S 1) | 89.90 | | |
| UDL-2 | (M 1) | 10.00 | (B-2) | 0.10 | (S 1) | 89.90 | | |
| UDL-3 | (M 1) | 10.00 | (B-3) | 0.10 | (S 1) | 89.90 | | |
| UDL-4 | (M 1) | 10.00 | (B-4) | 0.10 | (S 1) | 89.90 | | |
| UDL-5 | (M 1) | 10.00 | (B-5) | 0.10 | (S 1) | 89.90 | | |
| UDL-6 | (M 1) | 10.00 | (B-6) | 0.10 | (S 1) | 89.90 | | |
| UDL-7 | (M 1) | 10.00 | (B-7) | 0.10 | (S 1) | 89.90 | | |
| UDL-8 | (M 1) | 10.00 | (B-8) | 0.10 | (S 1) | 89.90 | | |
| UDL-9 | (M 1) | 10.00 | (B-9) | 0.10 | (S 1) | 89.90 | | |
| UDL-10 | (M 1) | 10.00 | (B-10) | 0.10 | (S 1) | 89.90 | | |
| UDL-11 | (M 1) | 10.00 | (B-2) | 0.10 | (S 1) | 62.93 | (S 2) | 26.97 |
| UDL-12 | (M 1) | 10.00 | (B-9) | 0.10 | (S 1) | 62.93 | (S 2) | 26.97 |
| UDL-13 | (M 1) | 10.00 | (B-10) | 0.10 | (S 1) | 62.93 | (S 2) | 26.97 |
| UDL-14 | (M 1) | 10.00 | (B-5) | 1.00 | (S 1) | 89.00 | | |
| UDL-15 | (M 1) | 10.00 | (B-5) | 0.001 | (S 1) | 90.00 | | |
| UDL-16 | (M2) | 10.00 | (B-1) | 0.10 | (S 1) | 89.90 | | |
| UDL-17 | (M2) | 10.00 | (B-2) | 0.10 | (S 1) | 89.90 | | |
| UDL-18 | (M2) | 10.00 | (B-3) | 0.10 | (S 1) | 89.90 | | |
| UDL-19 | (M2) | 10.00 | (B-4) | 0.10 | (S 1) | 89.90 | | |
| UDL-20 | (M2) | 10.00 | (B-5) | 0.10 | (S 1) | 89.90 | | |
| UDL-21 | (M2) | 10.00 | (B-6) | 0.10 | (S 1) | 89.90 | | |
| UDL-22 | (M2) | 10.00 | (B-7) | 0.10 | (S 1) | 89.90 | | |
| UDL-23 | (M2) | 10.00 | (B-8) | 0.10 | (S 1) | 89.90 | | |
| UDL-24 | (M2) | 10.00 | (B-9) | 0.10 | (S 1) | 89.90 | | |
| UDL-25 | (M2) | 10.00 | (B-10) | 0.10 | (S 1) | 89.90 | | |

**[Table 2]**

| Composition for forming organic film | Resin for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-26 | (M 3) | 10.00 | (B-1) | 0.10 | (S 1) | 89.90 | | |
| UDL-27 | (M 3) | 10.00 | (B-2) | 0.10 | (S 1) | 89.90 | | |
| UDL-28 | (M 3) | 10.00 | (B-3) | 0.10 | (S 1) | 89.90 | | |
| UDL-29 | (M 3) | 10.00 | (B-4) | 0.10 | (S 1) | 89.90 | | |
| UDL-30 | (M 3) | 10.00 | (B-5) | 0.10 | (S 1) | 89.90 | | |
| UDL-31 | (M 3) | 10.00 | (B-6) | 0.10 | (S 1) | 89.90 | | |
| UDL-32 | (M 3) | 10.00 | (B-7) | 0.10 | (S 1) | 89.90 | | |
| UDL-33 | (M 3) | 10.00 | (B-8) | 0.10 | (S 1) | 89.90 | | |
| UDL-34 | (M 3) | 10.00 | (B-9) | 0.10 | (S 1) | 89.90 | | |
| UDL-35 | (M 3) | 10.00 | (B-10) | 0.10 | (S 1) | 89.90 | | |
| UDL-36 | (M 4) | 10.00 | (B-1) | 0.10 | (S 1) | 89.90 | | |
| UDL-37 | (M 4) | 10.00 | (B-2) | 0.10 | (S 1) | 89.90 | | |
| UDL-38 | (M 4) | 10.00 | (B-3) | 0.10 | (S 1) | 89.90 | | |
| UDL-39 | (M 4) | 10.00 | (B-4) | 0.10 | (S 1) | 89.90 | | |
| UDL-40 | (M 4) | 10.00 | (B-5) | 0.10 | (S 1) | 89.90 | | |
| UDL-41 | (M 4) | 10.00 | (B-6) | 0.10 | (S 1) | 89.90 | | |
| UDL-42 | (M 4) | 10.00 | (B-7) | 0.10 | (S 1) | 89.90 | | |
| UDL-43 | (M 4) | 10.00 | (B-8) | 0.10 | (S 1) | 89.90 | | |
| UDL-44 | (M 4) | 10.00 | (B-9) | 0.10 | (S 1) | 89.90 | | |
| UDL-45 | (M 4) | 10.00 | (B-10) | 0.10 | (S 1) | 89.90 | | |
| UDL-46 | (M 5) | 10.00 | (B-1) | 0.10 | (S 1) | 89.90 | | |
| UDL-47 | (M 5) | 10.00 | (B-2) | 0.10 | (S 1) | 89.90 | | |
| UDL-48 | (M 5) | 10.00 | (B-3) | 0.10 | (S 1) | 89.90 | | |
| UDL-49 | (M 5) | 10.00 | (B-4) | 0.10 | (S 1) | 89.90 | | |
| UDL-50 | (M 5) | 10.00 | (B-5) | 0.10 | (S 1) | 89.90 | | |

**[Table 3]**

| Composition for forming organic film | Resin for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-51 | (M 5) | 10.00 | (B-6) | 0.10 | (S1) | 89.90 | | |
| UDL-52 | (M 5) | 10.00 | (B-7) | 0.10 | (S 1) | 89.90 | | |
| UDL-53 | (M 5) | 10.00 | (B-8) | 0.10 | (S 1) | 89.90 | | |
| UDL-54 | (M 5) | 10.00 | (B-9) | 0.10 | (S 1) | 89.90 | | |
| UDL-55 | (M 5) | 10.00 | (B-10) | 0.10 | (S 1) | 89.90 | | |
| UDL-56 | (M 6) | 10.00 | (B-1) | 0.10 | (S 1) | 89.90 | | |
| UDL-57 | (M 6) | 10.00 | (B-2) | 0.10 | (S 1) | 89.90 | | |
| UDL-58 | (M 6) | 10.00 | (B-3) | 0.10 | (S 1) | 89.90 | | |
| UDL-59 | (M 6) | 10.00 | (B-4) | 0.10 | (S 1) | 89.90 | | |
| UDL-60 | (M 6) | 10.00 | (B-5) | 0.10 | (S 1) | 89.90 | | |
| UDL-61 | (M 6) | 10.00 | (B-6) | 0.10 | (S 1) | 89.90 | | |
| UDL-62 | (M 6) | 10.00 | (B-7) | 0.10 | (S 1) | 89.90 | | |
| UDL-63 | (M 6) | 10.00 | (B-8) | 0.10 | (S 1) | 89.90 | | |
| UDL-64 | (M 6) | 10.00 | (B-9) | 0.10 | (S 1) | 89.90 | | |
| UDL-65 | (M 6) | 10.00 | (B-10) | 0.10 | (S 1) | 89.90 | | |
| Comparative UDL-1 | (M 1) | 10.00 | (R-1) | 0.10 | (S 1) | 89.9 | | |
| Comparative UDL-2 | (M 2) | 10.00 | (R-1) | 0.10 | (S 1) | 89.9 | | |
| Comparative UDL-3 | (M 3) | 10.00 | (R-1) | 0.10 | (S 1) | 89.9 | | |
| Comparative UDL-4 | (M 4) | 10.00 | (R-1) | 0.10 | (S 1) | 89.9 | | |
| Comparative UDL-5 | (M 5) | 10.00 | (R-1) | 0.10 | (S 1) | 89.9 | | |
| Comparative UDL-6 | (M 6) | 10.00 | (R-1) | 0.10 | (S 1) | 89.9 | | |
| Comparative UDL-7 | (M 1) | 10.00 | (R-2) | 0.10 | (S 1) | 89.9 | | |
| Comparative UDL-8 | (M 1) | 10.00 | | | (S 1) | 90.0 | | |
| Comparative UDL-9 | (M 2) | 10.00 | | | (S 1) | 90.0 | | |
| Comparative UDL-10 | (M 3) | 10.00 | | | (S 1) | 90.0 | | |
| Comparative UDL-11 | (M 4) | 10.00 | | | (S1) | 90.0 | | |
| Comparative UDL-12 | (M 5) | 10.00 | | | (S 1) | 90.0 | | |
| Comparative UDL-13 | (M 6) | 10.00 | | | (S 1) | 90.0 | | |

### [Fabrication of Silicon Wafer Having Organic Cured Film Formed Thereon Using Compositions for Forming Organic Film (UDL-1 to 65 and Comparative UDL-1 to 13)]

Using the coater/developer "CLEAN TRACK LITHIUS Pro AP" from Tokyo Electron Limited, 2 ml of each of the compositions for forming an organic film (UDL-1 to 65 and comparative UDL-1 to 13) prepared as described above was discharged onto the center of a silicon wafer, rotated at the rotation speed to achieve the average film thickness described in Tables 4 to 6, and spread. Thereafter, by carrying out baking at 350°C, a coating film of the composition for forming an organic film was formed. While rotating the silicon wafer at a speed of 1000 rpm, a removing solution discharge nozzle was moved at a speed of 5 mm/s from the outer circumference of the silicon wafer to a position 3 mm to the center with a removing solution (a mixed solution of propylene glycol monomethyl ether acetate and propylene glycol monomethyl ether (30:70, mass ratio)) discharged in a discharge amount of 2 mL/s. At that position, the removing solution was further discharged for 5 seconds in a discharge amount of 2 mL/s. Thereafter, discharge of the discharge solution was stopped and the silicon wafer was rotated for another 30 seconds at a speed of 1000 rpm. Next, the silicon wafer was heated at 350°C for 60 seconds, thereby obtaining a silicon wafer having an organic film (organic cured film) of each example formed thereon.

### [Evaluation of Solvent Resistance: Examples 1-1 to 1-65 and Comparative Examples 1-1 to 1-13]

By the above method, an organic film was formed on the silicon wafer using each of the compositions for forming an organic film (UDL-1 to 65 and comparative UDL-1 to 13), and the film thickness was measured. Next, a PGMEA solvent was dispensed on each organic film, allowed to stand for 30 seconds, spin-dried, and baked at 100°C for 60 seconds to evaporate the PGMEA, and the film thickness was measured. The film thickness before dispensing the PGMEA solvent was defined as X, the film thickness after dispensing the PGMEA solvent was defined as X1, and the absolute value of the value determined by {(X1 - X)/X} × 100 was defined as the rate of change in film thickness (%). A rate of change in film thickness of less than 0.5% was considered good, while a rate of change of 0.5% or more was considered poor. The results are shown in Tables 4 to 6 below.

### [Evaluation of In-Plane Uniformity: Examples 1-1 to 1-65 and Comparative Examples 1-1 to 1-13]

An organic film was formed on a silicon wafer by the above method using each of the compositions for forming an organic film (UDL-1 to 65 and comparative UDL-1 to 13), and the film thickness was measured within a radius of 145 mm from the center of the organic film. The maximum value of film thickness was defined as Xmax, the minimum value of film thickness as Xmin, and the average film thickness as Xaverage, and the value determined by {(Xmax - Xmin)/Xaverage} × 100 was defined as the in-plane uniformity (%). An in-plane uniformity of less than 2% was considered A (good), an in-plane uniformity of 2% or more to less than 3% was considered B, and an in-plane uniformity of 3% or more was considered C (poor). The results are shown in Tables 4 to 6.

**[Table 4]**

| | Composition for forming organic film | Average film thickness | Solvent resistance | In-plane uniformity |
|---|---|---|---|---|
| Example 1-1 | UDL-1 | 500nm | Good | B |
| Example 1-2 | UDL-2 | 500nm | Good | A |
| Example 1-3 | UDL-3 | 500nm | Good | A |
| Example 1-4 | UDL-4 | 500nm | Good | B |
| Example 1-5 | UDL-5 | 500nm | Good | A |
| Example 1-6 | UDL-6 | 500nm | Good | A |
| Example 1-7 | UDL-7 | 500nm | Good | A |
| Example 1-8 | UDL-8 | 500nm | Good | A |
| Example 1-9 | UDL-9 | 500nm | Good | A |
| Example 1-10 | UDL-10 | 500nm | Good | A |
| Example 1-11 | UDL-11 | 500nm | Good | A |
| Example 1-12 | UDL-12 | 500nm | Good | A |
| Example 1-13 | UDL-13 | 500nm | Good | A |
| Example 1-14 | UDL-14 | 500nm | Good | A |
| Example 1-15 | UDL-15 | 500nm | Good | A |
| Example 1-16 | UDL-16 | 500nm | Good | B |
| Example 1-17 | UDL-17 | 500nm | Good | A |
| Example 1-18 | UDL-18 | 500nm | Good | A |
| Example 1-19 | UDL-19 | 500nm | Good | B |
| Example 1-20 | UDL-20 | 500nm | Good | A |
| Example 1-21 | UDL-21 | 500nm | Good | A |
| Example 1-22 | UDL-22 | 500nm | Good | A |
| Example 1-23 | UDL-23 | 500nm | Good | A |
| Example 1-24 | UDL-24 | 500nm | Good | A |
| Example 1-25 | UDL-25 | 500nm | Good | A |

**[Table 5]**

| | Composition for forming organic film | Average film thickness | Solvent resistance | In-plane uniformity |
|---|---|---|---|---|
| Example 1-26 | UDL-26 | 500nm | Good | B |
| Example 1-27 | UDL-27 | 500nm | Good | A |
| Example 1-28 | UDL-28 | 500nm | Good | A |
| Example 1-29 | UDL-29 | 500nm | Good | B |
| Example 1-30 | UDL-30 | 500nm | Good | A |
| Example 1-31 | UDL-31 | 500nm | Good | A |
| Example 1-32 | UDL-32 | 500nm | Good | A |
| Example 1-33 | UDL-33 | 500nm | Good | A |
| Example 1-34 | UDL-34 | 500nm | Good | A |
| Example 1-35 | UDL-35 | 500nm | Good | A |
| Example 1-36 | UDL-36 | 500nm | Good | B |
| Example 1-37 | UDL-37 | 500nm | Good | A |
| Example 1-38 | UDL-38 | 500nm | Good | A |
| Example 1-39 | UDL-39 | 500nm | Good | B |
| Example 1-40 | UDL-40 | 500nm | Good | A |
| Example 1-41 | UDL-41 | 500nm | Good | A |
| Example 1-42 | UDL-42 | 500nm | Good | A |
| Example 1-43 | UDL-43 | 500nm | Good | A |
| Example 1-44 | UDL-44 | 500nm | Good | A |
| Example 1-45 | UDL-45 | 500nm | Good | A |
| Example 1-46 | UDL-46 | 500nm | Good | B |
| Example 1-47 | UDL-47 | 500nm | Good | A |
| Example 1-48 | UDL-48 | 500nm | Good | A |
| Example 1-49 | UDL-49 | 500nm | Good | B |
| Example 1-50 | UDL-50 | 500nm | Good | A |

**[Table 6]**

| | Composition for forming organic film | Average film thickness | Solvent resistance | In-plane uniformity |
|---|---|---|---|---|
| Example 1-51 | UDL-51 | 500nm | Good | A |
| Example 1-52 | UDL-52 | 500nm | Good | A |
| Example 1-53 | UDL-53 | 500nm | Good | A |
| Example 1-54 | UDL-54 | 500nm | Good | A |
| Example 1-55 | UDL-55 | 500nm | Good | A |
| Example 1-56 | UDL-56 | 500nm | Good | B |
| Example 1-57 | UDL-57 | 500nm | Good | A |
| Example 1-58 | UDL-58 | 500nm | Good | A |
| Example 1-59 | UDL-59 | 500nm | Good | B |
| Example 1-60 | UDL-60 | 500nm | Good | A |
| Example 1-61 | UDL-61 | 500nm | Good | A |
| Example 1-62 | UDL-62 | 500nm | Good | A |
| Example 1-63 | UDL-63 | 500nm | Good | A |
| Example 1-64 | UDL-64 | 500nm | Good | A |
| Example 1-65 | UDL-65 | 500nm | Good | A |
| Comparative Example 1-1 | Comparative UDL-1 | 500nm | Good | C |
| Comparative Example 1-2 | Comparative UDL-2 | 500nm | Good | C |
| Comparative Example 1-3 | Comparative UDL-3 | 500nm | Good | C |
| Comparative Example 1-4 | Comparative UDL-4 | 500nm | Good | C |
| Comparative Example 1-5 | Comparative UDL-5 | 500nm | Good | C |
| Comparative Example 1-6 | Comparative UDL-6 | 500nm | Good | C |
| Comparative Example 1-7 | Comparative UDL-7 | 500nm | Good | C |
| Comparative Example 1-8 | Comparative UDL-8 | 500nm | Good | C |
| Comparative Example 1-9 | Comparative UDL-9 | 500nm | Good | C |
| Comparative Example 1-10 | Comparative UDL-10 | 500nm | Good | C |
| Comparative Example 1-11 | Comparative UDL-11 | 500nm | Good | C |
| Comparative Example 1-12 | Comparative UDL-12 | 500nm | Good | C |
| Comparative Example 1-13 | Comparative UDL-13 | 500nm | Good | C |

As shown in Tables 4 to 6, Examples 1-1 to 1-65, which used the compositions for forming an organic film (UDL-1) to (UDL-65) containing (B-1) to (B-10), which are the (B) polymer of the present invention, all exhibited good solvent resistance. Also, the in-plane uniformity was evaluated as A or B.

On the other hand, Comparative Examples 1-1 to 1-7, which used comparative (UDL-1) to comparative (UDL-7), compositions for forming an organic film containing the polymer (R-1) or (R-2) outside the scope of the present invention, and Comparative Examples 1-8 to 1-13, which used compositions for forming an organic film not containing a polymer similar to the (B) polymer of the present invention (comparative UDL-8 to 13), all exhibited poor in-plane uniformity (Evaluation C).

### [Evaluation of Hump Suppressing Property: Examples 2-1 to 2-65 and Comparative Examples 2-1 to 2-13]

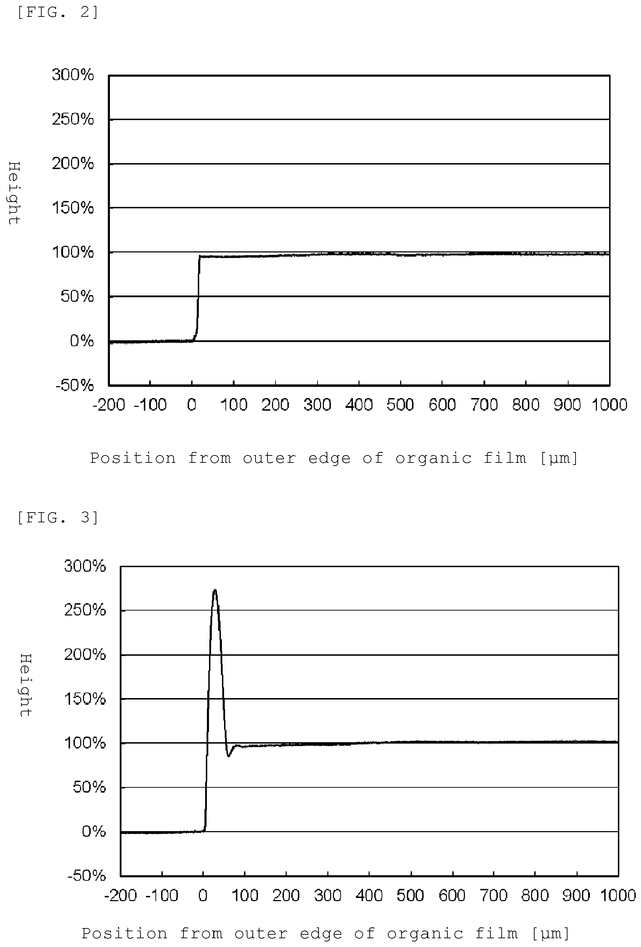

An organic film was formed on a silicon wafer by the above method using each of the compositions for forming an organic film (UDL-1 to 65 and comparative UDL-1 to 13), and the change in height from the outer edge of the organic film to a position 1000 µm toward the center of the silicon wafer was measured using Alpha-Step D-600 (stylus profiler) manufactured by KLA-Tencor Corporation. When the height of the silicon wafer was defined as 0, the case where the maximum height was less than 110% of the film thickness as shown in FIG. 2 was evaluated as A (good), the case where the maximum height was 110% or more to less than 150% was evaluated as B, and the case where a region with a height of 150% or more was generated as shown in FIG. 3 was evaluated as C (poor). The results are shown in Tables 7 to 9.

### [Evaluation of Filling: Examples 2-1 to 2-65 and Comparative Examples 2-1 to 2-13]

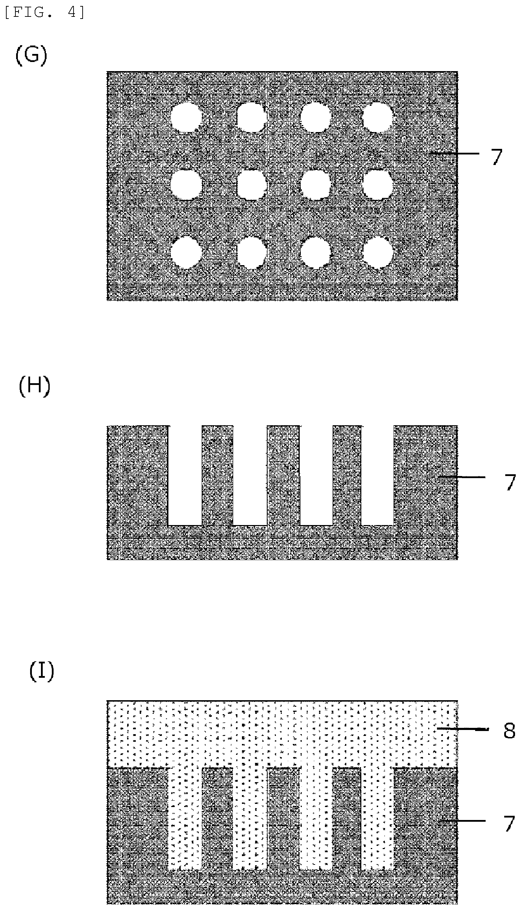

As shown in FIG. 4, a film was formed by the above method using each of the compositions for forming an organic film (UDL-1 to 65 and comparative UDL-1 to 13) on a SiO₂ wafer substrate with a dense hole pattern (hole diameter 0.2 µm, hole depth 1.0 µm, and distance between the centers of two adjacent holes 0.4 µm), thereby forming an organic film 8 as shown in FIG. 4(I) (cross-sectional view). The substrate used was a base substrate (SiO₂ wafer substrate) 7 with a dense hole pattern as shown in FIG. 4(G) (overhead view) and (H) (cross-sectional view). The cross-sectional shape of each wafer substrate obtained was observed using a scanning electron microscope (SEM) to check whether the hole interior was filled with the organic film with no voids. In the case where a composition for forming an organic film with poor filling property is used, voids are generated inside the holes. In the case where a composition for forming an organic film with good filling property is used, the hole interior is filled with the organic film with no voids in the present evaluation, as shown in FIG. 4(I). The case where no voids were generated was evaluated as good, and the case where voids were generated was evaluated as poor. The results are shown in Tables 7 to 9.

**[Table 7]**

| | Composition for forming organic film | Hump suppressing property evaluation | Filling property evaluation |
|---|---|---|---|
| Example 2-1 | UDL-1 | B | Good |
| Example 2-2 | UDL-2 | A | Good |
| Example 2-3 | UDL-3 | A | Good |
| Example 2-4 | UDL-4 | B | Good |
| Example 2-5 | UDL-5 | A | Good |
| Example 2-6 | UDL-6 | A | Good |
| Example 2-7 | UDL-7 | A | Good |
| Example 2-8 | UDL-8 | A | Good |
| Example 2-9 | UDL-9 | A | Good |
| Example 2-10 | UDL-10 | A | Good |
| Example 2-11 | UDL-11 | A | Good |
| Example 2-12 | UDL-12 | A | Good |
| Example 2-13 | UDL-13 | A | Good |
| Example 2-14 | UDL-14 | A | Good |
| Example 2-15 | UDL-15 | A | Good |
| Example 2-16 | UDL-16 | B | Good |
| Example 2-17 | UDL-17 | A | Good |
| Example 2-18 | UDL-18 | A | Good |
| Example 2-19 | UDL-19 | B | Good |
| Example 2-20 | UDL-20 | A | Good |
| Example 2-21 | UDL-21 | A | Good |
| Example 2-22 | UDL-22 | A | Good |
| Example 2-23 | UDL-23 | A | Good |
| Example 2-24 | UDL-24 | A | Good |
| Example 2-25 | UDL-25 | A | Good |

**[Table 8]**

| | Composition for forming organic film | Hump suppressing property evaluation | Filling property evaluation |
|---|---|---|---|
| Example 2-26 | UDL-26 | B | Good |
| Example 2-27 | UDL-27 | A | Good |
| Example 2-28 | UDL-28 | A | Good |
| Example 2-29 | UDL-29 | B | Good |
| Example 2-30 | UDL-30 | A | Good |
| Example 2-31 | UDL-31 | A | Good |
| Example 2-32 | UDL-32 | A | Good |
| Example 2-33 | UDL-33 | A | Good |
| Example 2-34 | UDL-34 | A | Good |
| Example 2-35 | UDL-35 | A | Good |
| Example 2-36 | UDL-36 | B | Good |
| Example 2-37 | UDL-37 | A | Good |
| Example 2-38 | UDL-38 | A | Good |
| Example 2-39 | UDL-39 | B | Good |
| Example 2-40 | UDL-40 | A | Good |
| Example 2-41 | UDL-41 | A | Good |
| Example 2-42 | UDL-42 | A | Good |
| Example 2-43 | UDL-43 | A | Good |
| Example 2-44 | UDL-44 | A | Good |
| Example 2-45 | UDL-45 | A | Good |
| Example 2-46 | UDL-46 | B | Good |
| Example 2-47 | UDL-47 | A | Good |
| Example 2-48 | UDL-48 | A | Good |
| Example 2-49 | UDL-49 | B | Good |
| Example 2-50 | UDL-50 | A | Good |

**[Table 9]**

| | Composition for forming organic film | Hump suppressing property evaluation | Filling property evaluation |
|---|---|---|---|
| Example 2-51 | UDL-51 | A | Good |
| Example 2-52 | UDL-52 | A | Good |
| Example 2-53 | UDL-53 | A | Good |
| Example 2-54 | UDL-54 | A | Good |
| Example 2-55 | UDL-55 | A | Good |
| Example 2-56 | UDL-56 | B | Good |
| Example 2-57 | UDL-57 | A | Good |
| Example 2-58 | UDL-58 | A | Good |
| Example 2-59 | UDL-59 | B | Good |
| Example 2-60 | UDL-60 | A | Good |
| Example 2-61 | UDL-61 | A | Good |
| Example 2-62 | UDL-62 | A | Good |
| Example 2-63 | UDL-63 | A | Good |
| Example 2-64 | UDL-64 | A | Good |
| Example 2-65 | UDL-65 | A | Good |
| Comparative Example 2-1 | Comparative UDL-1 | C | Poor |
| Comparative Example 2-2 | Comparative UDL-2 | C | Poor |
| Comparative Example 2-3 | Comparative UDL-3 | C | Poor |
| Comparative Example 2-4 | Comparative UDL-4 | C | Poor |
| Comparative Example 2-5 | Comparative UDL-5 | C | Poor |
| Comparative Example 2-6 | Comparative UDL-6 | C | Poor |
| Comparative Example 2-7 | Comparative UDL-7 | C | Poor |
| Comparative Example 2-8 | Comparative UDL-8 | C | Poor |
| Comparative Example 2-9 | Comparative UDL-9 | C | Poor |
| Comparative Example 2-10 | Comparative UDL-10 | C | Poor |
| Comparative Example 2-11 | Comparative UDL-11 | C | Poor |
| Comparative Example 2-12 | Comparative UDL-12 | C | Poor |
| Comparative Example 2-13 | Comparative UDL-13 | C | Poor |

As shown in Tables 7 to 9, Examples 2-1 to 2-65, which used the compositions for forming an organic film of the present invention (UDL-1 to 65), were confirmed to be excellent in hump suppressing property and filling property.

On the other hand, Comparative Examples 2-1 to 2-7, which used comparative (UDL-1) to comparative (UDL-7), compositions for forming an organic film containing the polymer (R-1) or (R-2) outside the scope of claims of the present invention, and Comparative Examples 2-8 to 2-13, which used compositions for forming an organic film not containing a polymer similar to the (B) polymer of the present invention (comparative UDL-8 to 13), had hump suppressing property evaluation of C (poor) and also had filling property evaluation of poor.

### [Patterning Test: Examples 3-1 to 3-65]

An organic film was formed on a SiO₂ wafer substrate by the above method (baking at 350°C) using each of the compositions for forming an organic film (UDL-1 to 65). The silicon-containing resist middle layer film material (SOG1) described below was applied on the organic film and baked at 200°C for 60 seconds to form a silicon-containing resist middle layer film with a film thickness of 35 nm. The monolayer resist for ArF described below was applied as the resist upper layer film material on it, and baked at 105°C for 60 seconds to form a photoresist film with a film thickness of 100 nm. The liquid immersion protective film material (TC-1) described below was applied on the photoresist film and baked at 90°C for 60 seconds to form a protective film with a film thickness of 50 nm.

As the silicon-containing resist middle layer film material (SOG1), a 2% solution of the following polymer in propylene glycol ethyl ether was prepared.

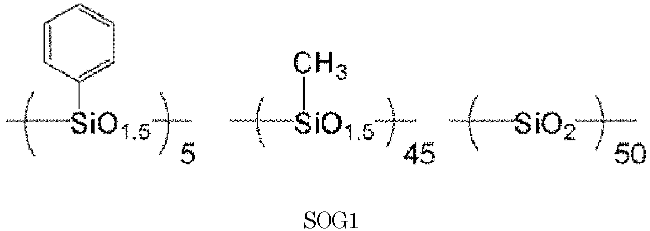

The resist upper layer film material (monolayer resist for ArF) was prepared by dissolving a polymer (RP1), an acid generator (PAG1), and a basic compound (Amine 1) in a solvent (PGMEA) containing 0.1% by mass of FC-430 (manufactured by Sumitomo 3M Ltd.) in the proportions shown in Table 10 and filtering the solution through a 0.1 µm filter made of fluororesin.

**[Table 10]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2500) |

The polymer (RP1), the acid generator (PAG1), and the basic compound (Amine 1) are shown below.

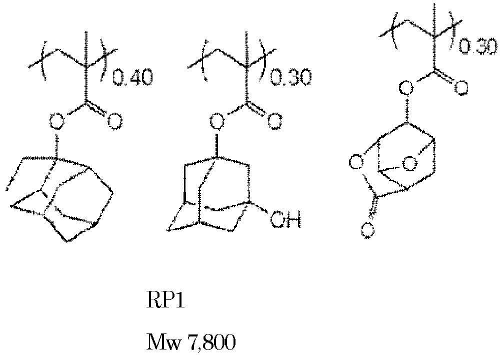

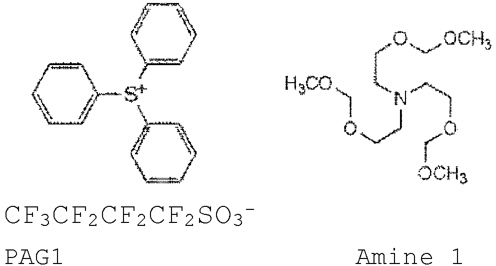

The liquid immersion protective film material (TC-1) was prepared by dissolving a polymer (PP1) in an organic solvent in the proportions shown in Table 11 and filtering the solution through a 0.1 µm filter made of fluororesin.

**[Table 11]**

| | Polymer (parts by mass) | Organic solvent (parts by mass) |
|---|---|---|
| TC-1 | PP1 (100) | Diisoamyl ether (2700) |
| | | 2-Methyl-1-butanol (270) |

The polymer (PP1) is shown below.

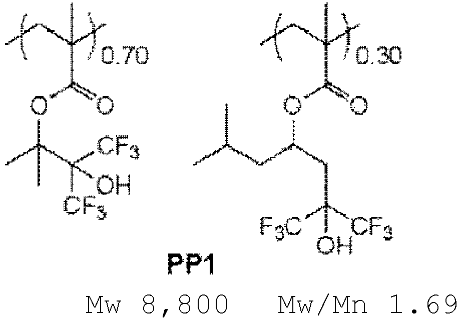

Next, the resulting substrate was exposed to light with an ArF liquid immersion exposure apparatus (manufactured by Nikon Corporation; NSR-S610C, NA 1.30, σ 0.98/0.65, 35° s-polarized dipole illumination, 6% halftone phase shift mask), baked at 100°C for 60 seconds (PEB), and developed with a 2.38% by mass aqueous tetramethylammonium hydroxide (TMAH) solution for 30 seconds. Thus, a 55 nm 1:1 positive line and space pattern (resist upper layer film pattern) was obtained.

Next, using an etching apparatus manufactured by Tokyo Electron Limited, Telius, the silicon-containing resist middle layer film was dry-etched (pattern transfer) using the resist upper layer film pattern as a mask to obtain a silicon-containing resist middle layer film pattern. The organic film was dry-etched (pattern transfer) using the obtained silicon-containing resist middle layer film pattern as a mask to obtain an organic film pattern. Then, the SiO₂ wafer substrate (SiO₂ film) was dry-etched (pattern transfer) using the obtained organic film pattern as a mask. The etching conditions were as follows.

### (Conditions for transferring the resist upper layer film pattern to the silicon-containing resist middle layer film)

| | |
|---|---|
| Chamber pressure | 10.0 Pa |
| RF power | 1,500 W |
| CF₄ gas flow rate | 75 mL/min |
| O₂ gas flow rate | 15 mL/min |
| Time | 15 sec |

### (Conditions for transferring the silicon-containing resist middle layer film pattern to the organic film)

| | |
|---|---|
| Chamber pressure | 2.0 Pa |
| RF power | 500 W |
| Ar gas flow rate | 75 mL/min |
| O₂ gas flow rate | 45 mL/min |
| Time | 120 sec |

### (Conditions for transferring the organic film pattern to the SiO₂ wafer substrate)

| | |
|---|---|
| Chamber pressure | 2.0 Pa |
| RF power | 2,200 W |
| C₅F₁₂ gas flow rate | 20 mL/min |
| C₂F₆ gas flow rate | 10 mL/min |
| Ar gas flow rate | 300 mL/min |
| O_{2S} gas flow rate | 60 mL/min |
| Time | 90 sec |

The results of observation of the cross sections of the obtained patterns with an electron microscope manufactured by Hitachi, Ltd. (S-4700) are shown in Tables 12 to 14.

**[Table 12]**

| | Composition for forming organic film | Shape after substrate transfer etching |
|---|---|---|
| Example 3-1 | UDL-1 | Good |
| Example 3-2 | UDL-2 | Good |
| Example 3-3 | UDL-3 | Good |
| Example 3-4 | UDL-4 | Good |
| Example 3-5 | UDL-5 | Good |
| Example 3-6 | UDL-6 | Good |
| Example 3-7 | UDL-7 | Good |
| Example 3-8 | UDL-8 | Good |
| Example 3-9 | UDL-9 | Good |
| Example 3-10 | UDL-10 | Good |
| Example 3-11 | UDL-11 | Good |
| Example 3-12 | UDL-12 | Good |
| Example 3-13 | UDL-13 | Good |
| Example 3-14 | UDL-14 | Good |
| Example 3-15 | UDL-15 | Good |
| Example 3-16 | UDL-16 | Good |
| Example 3-17 | UDL-17 | Good |
| Example 3-18 | UDL-18 | Good |
| Example 3-19 | UDL-19 | Good |
| Example 3-20 | UDL-20 | Good |
| Example 3-21 | UDL-21 | Good |
| Example 3-22 | UDL-22 | Good |
| Example 3-23 | UDL-23 | Good |
| Example 3-24 | UDL-24 | Good |
| Example 3-25 | UDL-25 | Good |

**[Table 13]**

| | Composition for forming organic film | Shape after substrate transfer etching |
|---|---|---|
| Example 3-26 | UDL-26 | Good |
| Example 3-27 | UDL-27 | Good |
| Example 3-28 | UDL-28 | Good |
| Example 3-29 | UDL-29 | Good |
| Example 3-30 | UDL-30 | Good |
| Example 3-31 | UDL-31 | Good |
| Example 3-32 | UDL-32 | Good |
| Example 3-33 | UDL-33 | Good |
| Example 3-34 | UDL-34 | Good |
| Example 3-35 | UDL-35 | Good |
| Example 3-36 | UDL-36 | Good |
| Example 3-37 | UDL-37 | Good |
| Example 3-38 | UDL-38 | Good |
| Example 3-39 | UDL-39 | Good |
| Example 3-40 | UDL-40 | Good |
| Example 3-41 | UDL-41 | Good |
| Example 3-42 | UDL-42 | Good |
| Example 3-43 | UDL-43 | Good |
| Example 3-44 | UDL-44 | Good |
| Example 3-45 | UDL-45 | Good |
| Example 3-46 | UDL-46 | Good |
| Example 3-47 | UDL-47 | Good |
| Example 3-48 | UDL-48 | Good |
| Example 3-49 | UDL-49 | Good |
| Example 3-50 | UDL-50 | Good |

**[Table 14]**

| | Composition for forming organic film | Shape after substrate transfer etching |
|---|---|---|
| Example 3-51 | UDL-51 | Good |
| Example 3-52 | UDL-52 | Good |
| Example 3-53 | UDL-53 | Good |
| Example 3-54 | UDL-54 | Good |
| Example 3-55 | UDL-55 | Good |
| Example 3-56 | UDL-56 | Good |
| Example 3-57 | UDL-57 | Good |
| Example 3-58 | UDL-58 | Good |
| Example 3-59 | UDL-59 | Good |
| Example 3-60 | UDL-60 | Good |
| Example 3-61 | UDL-61 | Good |
| Example 3-62 | UDL-62 | Good |
| Example 3-63 | UDL-63 | Good |
| Example 3-64 | UDL-64 | Good |
| Example 3-65 | UDL-65 | Good |

As shown in Tables 12 to 14, in all of Examples 3-1 to 3-65, which used the compositions for forming an organic film of Examples of the present invention (UDL-1 to 65), the resist upper layer film pattern was well transferred to the SiO₂ wafer substrate at the final stage, confirming that the compositions for forming an organic film of Examples of the present invention are suitably used for microfabrication by the multilayer resist method.

From the above, it can be seen that the composition for forming an organic film of the present invention is extremely useful as an organic film material to be used in the multilayer resist process since it has excellent film formability, a high degree of filling property, and excellent hump suppressing property. In addition, the patterning process of the present invention using the composition for forming an organic film of the present invention is capable of filling holes and trenches with a very high aspect ratio with no voids, is also capable of forming fine patterns with high precision, and can form organic films with suppressed humps, and can thus efficiently produce semiconductor elements and others.

The present description includes the following inventions.
[1] A composition for forming an organic film, the composition comprising (A) a material for forming an organic film, (B) a polymer having a repeating unit represented by the following formula (B1), and (C) a solvent: 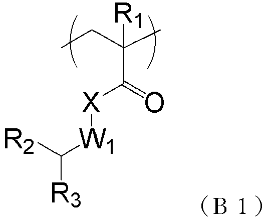 wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom.
[2] The composition for forming an organic film according to [1], wherein W₁ in the formula (B1) is a group represented by the following formula (B2): 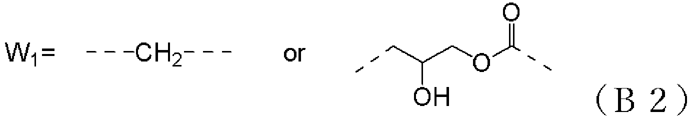 wherein broken lines represent a point of attachment to X and a point of attachment to the carbon atom to which R₂ and R₃ are bonded in the formula (B1), and W₁ has one of the structures represented by the formula (B2) or has two thereof.
[3] The composition for forming an organic film according to [1] or [2], wherein the polymer (B) further comprises one of or two or more of repeating units represented by the following general formula (B3): 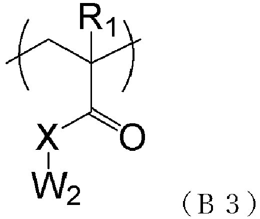 wherein R₁ and X are the same as described above, and W₂ is a monovalent organic group not containing fluorine atom and optionally containing an oxygen atom.
[4] The composition for forming an organic film according to [3], wherein W₂ in the formula (B3) is a group represented by the following formula (B4): 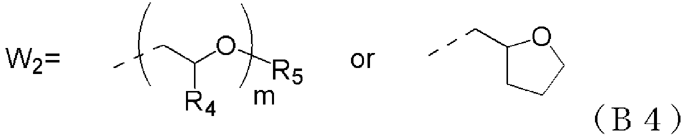 wherein R₄ is a hydrogen atom or a methyl group, R₅ is a hydrogen atom or a monovalent organic group having 1 to 10 carbon atoms and not containing fluorine atom, and m is an integer of 4 to 20.
[5] The composition for forming an organic film according to any one of [1] to [4], wherein the component (B) has a weight average molecular weight of 1000 to 30000.
[6] The composition for forming an organic film according to any one of [1] to [5], wherein a content of the component (B) is 0.01 parts by mass to 5 parts by mass based on 100 parts by mass of a content of the (A) material for forming an organic film.
[7] A method for forming an organic film to be used in a manufacturing process of a semiconductor device, the method comprising spin-coating the composition for forming an organic film according to any one of [1] to [6] on a substrate to be processed to obtain a coating film, and forming a cured film by a heat treatment at a temperature of 100°C or higher and 600°C or lower for a range of 10 to 600 seconds to form an organic film.
[8] patterning process comprising: forming an organic film on a body to be processed using the composition for forming an organic film according to any one of [1] to [6]; forming a silicon-containing resist middle layer film on the organic film using a silicon-containing resist middle layer film material; forming a resist upper layer film on the silicon-containing resist middle layer film using a resist upper layer film material composed of a photoresist composition; forming a circuit pattern in the resist upper layer film; transferring the pattern to the silicon-containing resist middle layer film by etching using as a mask the resist upper layer film in which the circuit pattern has been formed; transferring the pattern to the organic film by etching using as a mask the silicon-containing resist middle layer film to which the pattern has been transferred; and further forming the pattern in the body to be processed by etching using as a mask the organic film to which the pattern has been transferred.
[9] A patterning process comprising: forming an organic film on a body to be processed using the composition for forming an organic film according to any one of [1] to [6]; forming a silicon-containing resist middle layer film on the organic film using a silicon-containing resist middle layer film material; forming an organic antireflective film or an adhesion film on the silicon-containing resist middle layer film; forming a resist upper layer film on the organic antireflective film or adhesion film using a resist upper layer film material composed of a photoresist composition; forming a circuit pattern in the resist upper layer film; transferring the pattern to the organic antireflective film or adhesion film and the silicon-containing resist middle layer film by etching using as a mask the resist upper layer film in which the circuit pattern has been formed; transferring the pattern to the organic film by etching using as a mask the silicon-containing resist middle layer film to which the pattern has been transferred; and further forming the pattern in the body to be processed by etching using as a mask the organic film to which the pattern has been transferred.
[10] A patterning process comprising: forming an organic film on a body to be processed using the composition for forming an organic film according to any one of [1] to [6]; forming an inorganic hard mask selected from the group consisting of a silicon oxide film, a silicon nitride film, and a silicon oxynitride film on the organic film; forming a resist upper layer film on the inorganic hard mask using a resist upper layer film material composed of a photoresist composition; forming a circuit pattern in the resist upper layer film; transferring the pattern to the inorganic hard mask by etching using as a mask the resist upper layer film in which the circuit pattern has been formed; transferring the pattern to the organic film by etching using as a mask the inorganic hard mask to which the pattern has been transferred; and further forming the pattern in the body to be processed by etching using as a mask the organic film to which the pattern has been transferred.
[11] A patterning process comprising: forming an organic film on a body to be processed using the composition for forming an organic film according to any one of [1] to [6]; forming an inorganic hard mask selected from the group consisting of a silicon oxide film, a silicon nitride film, and a silicon oxynitride film on the organic film; forming an organic antireflective film or an adhesion film on the inorganic hard mask; forming a resist upper layer film on the organic antireflective film or adhesion film using a resist upper layer film material composed of a photoresist composition; forming a circuit pattern in the resist upper layer film; transferring the pattern to the organic antireflective film or adhesion film and the inorganic hard mask by etching using as a mask the resist upper layer film in which the circuit pattern has been formed; transferring the pattern to the organic film by etching using as a mask the inorganic hard mask to which the pattern has been transferred; and further forming the pattern in the body to be processed by etching using as a mask the organic film to which the pattern has been transferred.
[12] The patterning process according to [10] or [11], wherein formation of the inorganic hard mask is carried out by a CVD method or an ALD method.
[13] The patterning process according to any one of [8] to [12], wherein in formation of the circuit pattern, the circuit pattern is formed by lithography using light with a wavelength of 10 nm or more and 300 nm or less, direct drawing with electron beams, nanoimprinting, or a combination thereof.
[14] The patterning process according to any one of [8] to [13], wherein in formation of the circuit pattern, the circuit pattern is developed by alkali development or an organic solvent.
[15] The patterning process according to any one of [8] to [14], wherein the body to be processed is a semiconductor device substrate, or the semiconductor device substrate on which any of a metal film, a metal carbide film, a metal oxide film, a metal nitride film, a metal oxycarbide film, and a metal oxynitride film has been formed.
[16] The patterning process according to any one of [8] to [15], using as the body to be processed, one in which a metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.
[17] A polymer comprising a repeating unit represented by the following formula (B1): 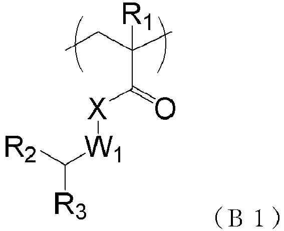 wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom.
[18] The polymer according to [17], wherein W₁ in the formula (B1) is a group represented by the following formula (B2): 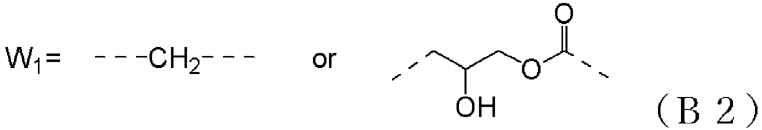 wherein broken lines represent a point of attachment to X and a point of attachment to the carbon atom to which R₂ and R₃ are bonded in the formula (B1), and W₁ has one of the structures represented by the formula (B2) or has two thereof.
[19] The polymer according to [17] or [18], wherein the polymer further comprises one of or two or more of repeating units represented by the following general formula (B3): 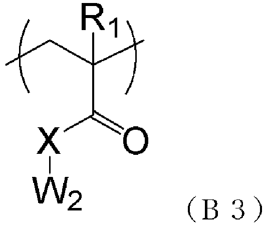 wherein R₁ and X are the same as described above, and W₂ is a monovalent organic group not containing fluorine atom and optionally containing an oxygen atom.
[20] The polymer according to [19], wherein W₂ in the formula (B3) is a group represented by the following formula (B4): 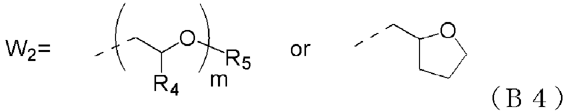 wherein R₄ is a hydrogen atom or a methyl group, R₅ is a hydrogen atom or a monovalent organic group having 1 to 10 carbon atoms and not containing fluorine atom, and m is an integer of 4 to 20.
[21]. The polymer according to any one of any one of [17] to [20], wherein the polymer has a weight average molecular weight of 1000 to 30000.

Note that the present invention is not limited to the embodiments described above. The embodiments described above are merely illustrations, and any embodiments having substantially the same configuration as and providing similar effects to the technical concept described in the claims of the present invention are encompassed in the technical scope of the present invention.

## Claims

1. A composition for forming an organic film, the composition comprising (A) a material for forming an organic film, (B) a polymer having a repeating unit represented by the following formula (B1), and (C) a solvent: 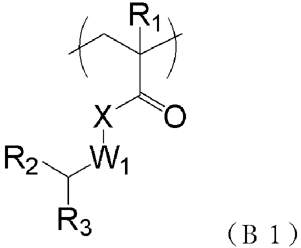 wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom.

2. The composition for forming an organic film according to claim 1, wherein W₁ in the formula (B1) is a group represented by the following formula (B2): 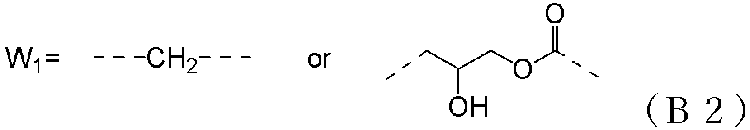 wherein broken lines represent a point of attachment to X and a point of attachment to the carbon atom to which R₂ and R₃ are bonded in the formula (B1), and W₁ has one of the structures represented by the formula (B2) or has two thereof.

3. The composition for forming an organic film according to claim 1 or 2, wherein the polymer (B) further comprises one of or two or more of repeating units represented by the following general formula (B3): 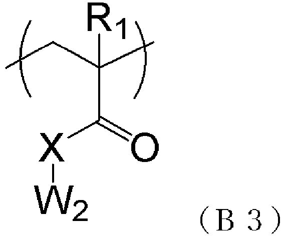 wherein R₁ and X are the same as described above, and W₂ is a monovalent organic group not containing fluorine atom and optionally containing an oxygen atom, preferably wherein W₂ in the formula (B3) is a group represented by the following formula (B4): 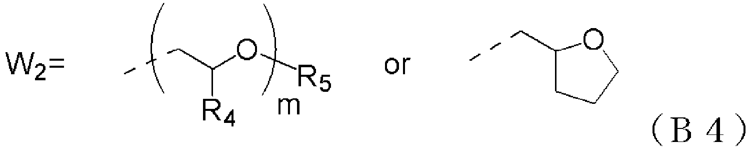 wherein R₄ is a hydrogen atom or a methyl group, R₅ is a hydrogen atom or a monovalent organic group having 1 to 10 carbon atoms and not containing fluorine atom, and m is an integer of 4 to 20.

4. The composition for forming an organic film according to any one of claims 1 to 3, wherein the component (B) has a weight average molecular weight of 1000 to 30000.

5. The composition for forming an organic film according to any one of claims 1 to 4, wherein a content of the component (B) is 0.01 parts by mass to 5 parts by mass based on 100 parts by mass of a content of the (A) material for forming an organic film.

6. A method for forming an organic film to be used in a manufacturing process of a semiconductor device, the method comprising spin-coating the composition for forming an organic film according to any one of claims 1 to 5 on a substrate to be processed to obtain a coating film, and forming a cured film by a heat treatment at a temperature of 100°C or higher and 600°C or lower for a range of 10 to 600 seconds to form an organic film.

7. A patterning process comprising: forming an organic film on a body to be processed using the composition for forming an organic film according to any one of claims 1 to 5; forming a silicon-containing resist middle layer film on the organic film using a silicon-containing resist middle layer film material; forming a resist upper layer film on the silicon-containing resist middle layer film using a resist upper layer film material composed of a photoresist composition; forming a circuit pattern in the resist upper layer film; transferring the pattern to the silicon-containing resist middle layer film by etching using as a mask the resist upper layer film in which the circuit pattern has been formed; transferring the pattern to the organic film by etching using as a mask the silicon-containing resist middle layer film to which the pattern has been transferred; and further forming the pattern in the body to be processed by etching using as a mask the organic film to which the pattern has been transferred, or
a patterning process comprising: forming an organic film on a body to be processed using the composition for forming an organic film according to any one of claim 1 to 5; forming a silicon-containing resist middle layer film on the organic film using a silicon-containing resist middle layer film material; forming an organic antireflective film or an adhesion film on the silicon-containing resist middle layer film; forming a resist upper layer film on the organic antireflective film or adhesion film using a resist upper layer film material composed of a photoresist composition; forming a circuit pattern in the resist upper layer film; transferring the pattern to the organic antireflective film or adhesion film and the silicon-containing resist middle layer film by etching using as a mask the resist upper layer film in which the circuit pattern has been formed; transferring the pattern to the organic film by etching using as a mask the silicon-containing resist middle layer film to which the pattern has been transferred; and further forming the pattern in the body to be processed by etching using as a mask the organic film to which the pattern has been transferred, or
a patterning process comprising: forming an organic film on a body to be processed using the composition for forming an organic film according any one of claim 1 to 5; forming an inorganic hard mask selected from the group consisting of a silicon oxide film, a silicon nitride film, and a silicon oxynitride film on the organic film; forming a resist upper layer film on the inorganic hard mask using a resist upper layer film material composed of a photoresist composition; forming a circuit pattern in the resist upper layer film; transferring the pattern to the inorganic hard mask by etching using as a mask the resist upper layer film in which the circuit pattern has been formed; transferring the pattern to the organic film by etching using as a mask the inorganic hard mask to which the pattern has been transferred; and further forming the pattern in the body to be processed by etching using as a mask the organic film to which the pattern has been transferred, or
a patterning process comprising: forming an organic film on a body to be processed using the composition for forming an organic film according to any one of claim 1 to 5; forming an inorganic hard mask selected from the group consisting of a silicon oxide film, a silicon nitride film, and a silicon oxynitride film on the organic film; forming an organic antireflective film or an adhesion film on the inorganic hard mask; forming a resist upper layer film on the organic antireflective film or adhesion film using a resist upper layer film material composed of a photoresist composition; forming a circuit pattern in the resist upper layer film; transferring the pattern to the organic antireflective film or adhesion film and the inorganic hard mask by etching using as a mask the resist upper layer film in which the circuit pattern has been formed; transferring the pattern to the organic film by etching using as a mask the inorganic hard mask to which the pattern has been transferred; and further forming the pattern in the body to be processed by etching using as a mask the organic film to which the pattern has been transferred.

8. The patterning process according to claim 7, wherein formation of the inorganic hard mask is carried out by a CVD method or an ALD method.

9. The patterning process according to claim 7, wherein in formation of the circuit pattern, the circuit pattern is formed by lithography using light with a wavelength of 10 nm or more and 300 nm or less, direct drawing with electron beams, nanoimprinting, or a combination thereof.

10. The patterning process according to claim 7, wherein in formation of the circuit pattern, the circuit pattern is developed by alkali development or an organic solvent.

11. The patterning process according to claim 7, wherein the body to be processed is a semiconductor device substrate, or the semiconductor device substrate on which any of a metal film, a metal carbide film, a metal oxide film, a metal nitride film, a metal oxycarbide film, and a metal oxynitride film has been formed, preferably
in which a metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

12. A polymer comprising a repeating unit represented by the following formula (B1): 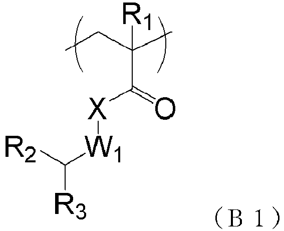 wherein R₁ is a hydrogen atom or a methyl group, R₂ and R₃ are each independently a monovalent organic group having 10 to 20 carbon atoms and not containing fluorine atom, X is a nitrogen atom or an oxygen atom, and W₁ is a single bond or a divalent linking group having 1 to 10 carbon atoms and not containing fluorine atom and optionally containing an oxygen atom.

13. The polymer according to claim 12, wherein W₁ in the formula (B1) is a group represented by the following formula (B2): 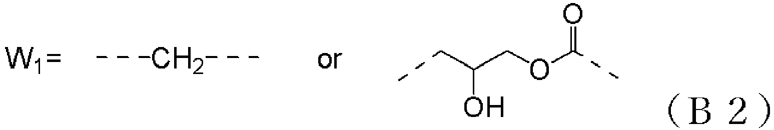 wherein broken lines represent a point of attachment to X and a point of attachment to the carbon atom to which R₂ and R₃ are bonded in the formula (B1), and W₁ has one of the structures represented by the formula (B2) or has two thereof.

14. The polymer according to claim 12 or 13, wherein the polymer further comprises one of or two or more of repeating units represented by the following general formula (B3): 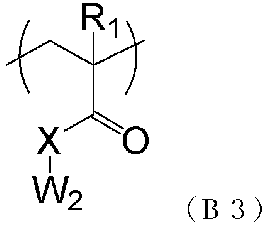
wherein R₁ and X are the same as described above, and W₂ is a monovalent organic group not containing fluorine atom and optionally containing an oxygen atom, preferably
wherein W₂ in the formula (B3) is a group represented by the following formula (B4): 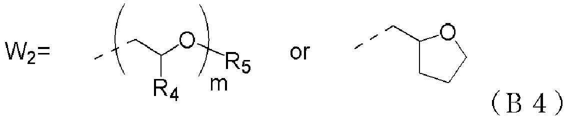 wherein R₄ is a hydrogen atom or a methyl group, R₅ is a hydrogen atom or a monovalent organic group having 1 to 10 carbon atoms and not containing fluorine atom, and m is an integer of 4 to 20.

15. The polymer according to any one of claims 12 to 14, wherein the polymer has a weight average molecular weight of 1000 to 30000.
